# EUROPEAN PATENT SPECIFICATION

(11) **EP 1 627 732 B1**
(45) Date of publication and mention of the grant of the patent: **31.10.2007**
(21) Application number: 05017749.2
(22) Date of filing: 16.08.2005
(51) Int. Cl.: B41C 1/10, G03F 7/039

(54) **Planographic printing plate precursor**
Flachdruckplattenvorläufer
Précurseur de plaque d'impression planographique

(30) Priority: 18.08.2004 JP 2004238183
(43) Date of publication of application: 22.02.2006
(73) Proprietor: FUJIFILM Corporation, Minato-ku Tokyo (JP)
(72) Inventor: Hatanaka, Yusuke, Yoshida-cho Haibara-gun Shizuoka-ken (JP); Kawauchi, Ikuo, Yoshida-cho Haibara-gun Shizuoka-ken (JP)
(74) Representative: HOFFMANN EITLE

(56) References cited:
- EP-A- 1 204 000
- EP-A- 1 208 014
- US-A- 4 737 426

## Description

### BACKGROUND OF THE INVENTION

### FIELD OF THE INVENTION

The invention relates to a planographic printing plate precursor having a recording layer that contains a positive photosensitive composition of which solubility to an alkaline aqueous solution varies owing to exposure to infrared rays, in more detail a positive planographic printing plate precursor that allows performing so-called direct print making by scanning infrared laser light based on a digital signal from a computer or the like.

### DESCRIPTION OF THE RELATED ART

Recently, with an advance in an image formation technology, direct plate making has become possible, without using a film script, by scanning a plate surface with narrowly focused laser light to form a character script or an image script directly on the plate surface. Such a plate material is called a computer to plate (CTP) planographic printing plate precursor.

A thermal positive planographic printing plate precursor is an image forming material in which, by irradiating laser light to cause a photo-thermal conversion in a recording layer, the alkali-solubility of the recording layer is increased to form a positive image. In such a thermal positive type planographic printing plate precursor, in a recording layer owing to the laser exposure, a delicate change in an interaction between binder molecules is made use of as an image formation principle. Accordingly, there is a problem in that difference in the alkali-solubility between exposed portion/unexposed portion (i.e., solubility discrimination) is too small to achieve sufficient development latitude (sufficient development stability), depending on conditions used. As a result, there are possibilities, due to variation in the activity of a developer, that the development failure and white blank in an image portion are caused.

Regarding the problems as mentioned above, in order to expand the development latitude and to improve the image forming properties of a recording layer to a practically acceptable level, an image recording material in which a recording layer is formed into a multi-layer structure has been proposed.

For instance, a technology in which a polymer that has as a main chain polyvinyl alcohol having an acetal unit as a pendant group is added to a positive working composition has been proposed (for instance, Japanese Patent Application National Publication (Laid-Open) No. 2003-530581). Although such a polymer is high in the solubility to an alkaline developer and reduces the development failure in an exposed portion, there are problems in that the alkali-solubility at an unexposed portion is also enhanced and thus the development latitude is not improved after all and that the inking property in the unexposed portion (image portion) is rather deteriorated.

EP 1 204 000 A1 discloses a photosensitive lithographic printing plate comprising a support and a photosensitive layer. The photosensitive layer comprises a polyvinyl alcohol resin binder modified with an acetal skeleton comprising an aliphatic cyclic structure.

US 4 737 426 discloses compounds of the general formula (I):

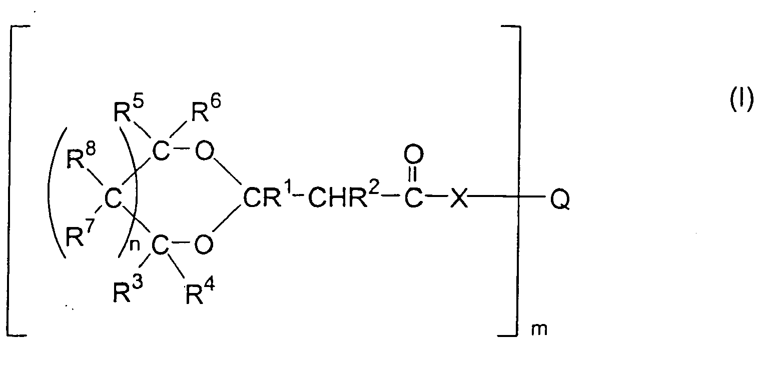

In conjunction with compounds that donate acid when exposed to actinic radiation, compounds of formula (I) are suitable for use as positive photoresists. In formula (I) R¹ and R² are hydrogen, alkyl, aryl, cyclic aryl, arylkyl or alcyryl; R² to R⁸ are hydrogen or lower alkyl; X is -O- or -NR⁹-; where R⁹ is hydrogen or C1 to C4 alkyl, N is 0 or 1, M is 2, 3 or 4 and Q is an organic radical of valency m.

WO 01/09682 A2 discloses a positive-acting photoresist composition which is heat-sensitive. It comprises a watersoluble heat-sensitive resin, an adhesion promoter and a radiation absorbing agent - a dye or a pigment.

### SUMMARY OF THE INVENTION

An object of the invention that is carried out in view of overcoming these disadvantages of conventional technologies is to provide a CTP type infrared-sensitive positive planographic printing plate precursor that enables direct plate making by recording with a solid laser or semiconductor laser that radiates infrared rays based on a digital signal from a computer or the like, is wide in the development latitude and excellent in the inking property in an image portion.

The inventors, after studying hard, discovered that conditions that achieve the foregoing object can be obtained by applying a photosensitive composition that contains a polymer compound having a specific structure and an onium salt to a recording layer.

That is, a positive planographic printing plate precursor according to the invention includes a substrate; and a positive planographic printing plate precursor, comprising:
a substrate; and
a recording layer that is disposed on the substrate and contains a polymer compound represented by formula (I) below, an onium salt represented by formula (A) below, an infrared absorber and a novolac resin 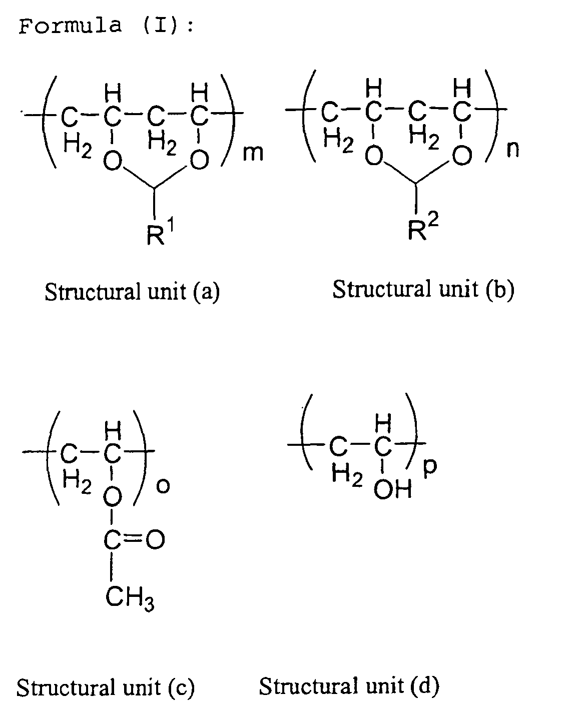
wherein, in formula (I), R1 represents a hydrocarbon group and R² represents an aromatic group having, as a substituent group, a hydroxyl group. M = 5 to 40 % by mole, n = 10 to 60 % by mole, o = 1 to 20 % by mole and p = 5 to 50 % by mole ;

Formula (A): M⁺X⁻

wherein, in the formula (A), M+ represents a cation selected from sulfonium or iodonium that may have a substituent group, and X- represents a counter anion.

Although the mechanisms of the operations of the invention have not been elucidated yet, it is assumed that since a polymer compound having an acetal structure like the formula (I) has many oxygen atoms, when it is used together with an onium salt, a particularly strong interaction is caused in an unexposed portion, to form a strong film which exhibits high dissolution inhibition property to a developer. On the other hand, in an exposed portion, it is considered that as the interaction is readily released owing to heat or the like to secure high developability caused by an acid group of the specific structure polymer, discrimination is improved throughout the layer and the development latitude is expanded. Further, it is assumed that the lipophilicity of an image portion is specifically improved and thereby excellent inking property is exhibited.

Since an unexposed portion that forms an image portion maintains a very strong dissolution inhibition effect to the developer, as mentioned above, it is assumed that the plate is also prevented from being scratched when the plate is handled, is difficult to cause undesired dissolution from the scratches during development and can secure the inking property due to the hydrophobic characteristics of a film.

According to the invention, there is obtained a positive planographic printing plate precursor that enables direct plate making by scanning exposure based on a digital signal from a computer or the like, has wide development latitude and is excellent in the inking property of an image portion.

### DETAILED DESCRIPTION OF THE INVENTION

In what follows, the invention will be described in details.

A recording layer of a positive planographic printing plate precursor according to the invention is a recording layer made of a positive photosensitive composition containing the specific structure polymer, an onium salt and an infrared absorber, as defined in claim 1.

The specific structure polymer which is a characteristic component of the photosensitive composition constituting a recording layer of the planographic printing plate precursor according to the invention will be described hereinbelow.

### (Specific structure polymer)

The specific structure polymer that is used in a recording layer of the positive planographic printing plate precursor according to the invention is a polymer compound represented by a formula (I) below. The specific structure polymer is an alkali-soluble polymer.

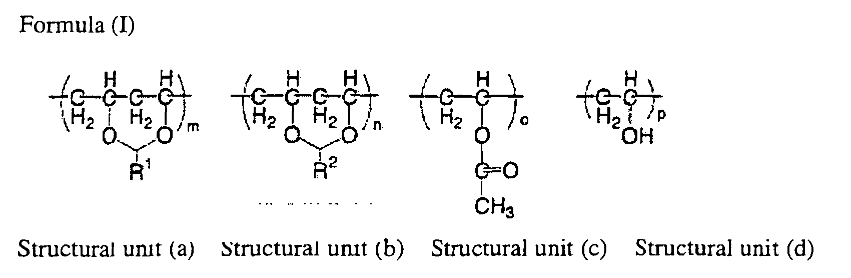

In the formula (I), R¹ represents a hydrocarbon group and R² represents an aromatic group having a hydroxyl group as a substituent group. M is in the range of 5 to 40% by mole; n, 10 to 60% by mole; o, 1 to 10% by mole; and p, 5 to 50% by mole.

In the structural unit (a), R¹ represents a hydrocarbon group, and a straight, branched or cyclic alkyl group are preferably cited.

As the R¹, an alkyl group having 1 to 12 carbon atoms (preferably 3 to 10 carbon atoms) is preferable. Specifically, a methyl group, an ethyl group, a propyl group, a butyl group, a pentyl group, a hexyl group, a heptyl group, an octyl group, a nonyl group, a decyl group, a undecyl group, a dodecyl group, a tridecyl group, a hexadecyl group, an octadecyl group, an eicosyl group, an isopropyl group, an isobutyl group, a s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group can be cited. Among these, an alkyl group having 3 to 10 carbon atoms is preferable.

In the formula (I), m that is a copolymerization ratio of the structural unit (a) is in the range of 5 to 40% by mole, preferably in the range of 10 to 35% by mole and more preferably in the range of 15 to 30% by mole.

In a polymer compound represented by the formula (I), the structural unit (a) may contain only structural units (a) having the same R¹ or a plurality of kinds of the structural units (a) having the R¹ different from each other.

In the structural unit (b), R² represents an aromatic group having a hydroxyl group as a substituent group. As an aromatic ring contained in the R², a benzene ring, a naphthalene ring, an anthracene ring and the like can be cited.

The R², indispensably having a hydroxyl group as a substituent group, may have substituent groups other than the hydroxyl group. As a substituent group that can be introduced, a mono-valent non-metal atomic group other than hydrogen can be used. Preferable examples include a halogen atom (-F, -Br, -Cl and -I), a hydroxyl group, an alkoxy group, an aryloxy group and the like.

In the polymer compound that is represented by the formula (I), the structural unit (b) may contains only structural units (b) having the same R² or a plurality of kinds of structural units (b) having the R² different from each other.

In the formula (I), n that is a copolymerization ratio of the structural unit (b) is in the range of 10 to 60% by mole, preferably in the range of 20 to 55% by mole and more preferably in the range of 30 to 50% by mole.

In the formula (I), o that is a copolymerization ratio of the structural unit (c) is in the range of 1 to 20% by mole, preferably in the range of 2 to 15% by mole and more preferably in the range of 3 to 10 % by mole.

Furthermore, in the formula (I), p that is a copolymerization ratio of the structural unit (d) is in the range of 5 to 50% by mole, preferably in the range of 10 to 45% by mole and more preferably in the range of 15 to 40% by mole.

A polymer compound represented by the formula (I) may contain structural units other than the structural units (a), (b), (c) and (d).

Among polymer compounds represented by the formula (I), as the specific structure polymer in the invention, polymer compounds represented by the formula (II) below are more preferable.

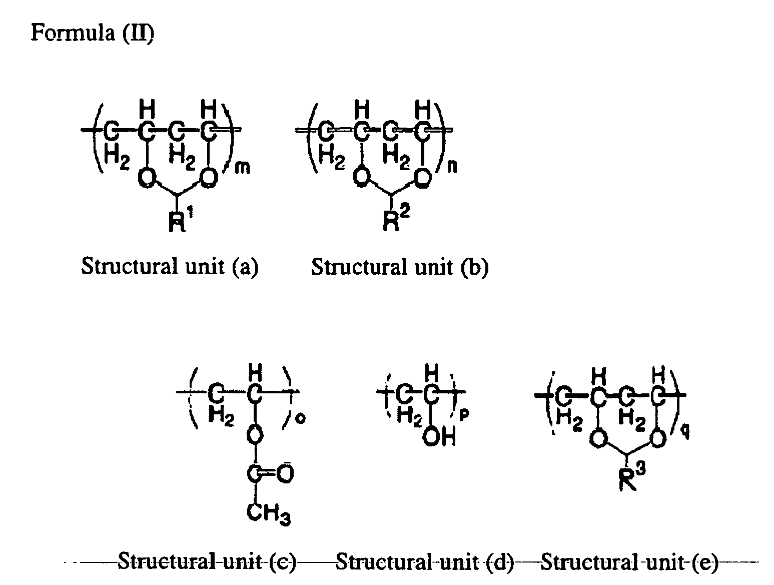

In the formula (II), structural units (a), (b), (c) and (d) are the same as the structural units (a), (b), (c) and (d) in the formula (I) and preferable ranges are also same.

In the structural unit (e), R³ represents -(CH₂)_{X}COOH, -C = CH or a group shown below. X represents an integer equal to 1 or more and preferably an integer of 1 to 12. Q is in the range of 0 to 20% by mole.

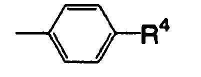

In the formula, R⁴ represents -COOH, -(CH₂)ₓCOOH or -O-(CH₂)_{X}COOH. X represents an integer equal to 1 or more and preferably an integer of 1 to 12.

In the formula (II), q that is a copolymerization ratio of the structural unit (e) is in the range of 0 to 20% by mole, preferably in the range of 3 to 17% by mole and more preferably in the range of 5 to 15 % by mole.

In the polymer compound that is represented by the formula (II), the structural unit (e) may contain only structural units (e) having the same R³ or a plurality of kinds of structural units (e) having the R³ different from each other.

A content of the specific structure polymer in the photosensitive composition that forms a photosensitive layer is, from a viewpoint of forming an excellent recording layer, preferably in the range of 10 to 99% by mass, more preferably in the range of 30 to 95% by mass, and further more preferably in the range of 50 to 90% by mass.

### (Other Polymer Compounds)

From a viewpoint of further improving the performances thereof, the photosensitive composition used in the invention may contain, in addition to the specific structure polymer, a polymer other than the specific structure polymer.

The type of the other polymer compound (polymer) that can be used together with the specific structure polymer is not particularly restricted, and may be appropriately selected in accordance with an object. In general, from a viewpoint of not marring the positive photosensitivity, an alkali-soluble polymer is used.

As preferable alkali-soluble resins that can be used together with the specific structure polymer, those having an acidic group cited in (1) through (6) shown below on a main chain and/or side chain of a polymer can be cited.
(1) phenol (-Ar-OH),
(2) sulfone amide (-SO₂NH-R),
(3) substituted sulfoneamido based acid group (hereinafter, referred to as active imido group) [-SO₂NHCOR, -SO₂NHSO₂R, -CONHSO₂R]
(4) carboxylic acid group (-CO₂H),
(5) sulfonic acid group (-SO₃H), and
(6) phosphoric acid group (-OPO₃H₂)

Ar in the above-mentioned groups (1) to (6) represents a divalent aryl bonding group and R represents a hydrogen or a hydrocarbon group.

Among the alkali-soluble resin comprising the acidic group selected from the above-mentioned (1) to (6), an alkali-soluble resin comprising (1) phenol, (2) sulfone amide, or (3) active imido group is preferable and an alkali-soluble resin comprising (1) phenol or (2) sulfone amide is more preferable in terms of assurance of the sufficient solubility in an alkaline developer, development latitude, and film strength. An alkali-soluble resin comprising (1) phenol on a main chain and/or side chain of a polymer is the most preferable.
(1) Examples of the alkali-soluble resin comprising phenol group may include:
   novolak resin such as condensation polymers of phenol and formaldehyde; condensation polymers of m-cresol and formaldehyde, condensation polymers of p-cresol and formaldehyde, condensation polymers of m-/p-mixed cresol and formaldehyde, and condensation polymers of phenol, cresol (m-, p-, or m-/p-mixture) and formaldehyde; and
   condensation copolymers of pyrogallol and acetone. Further, copolymers obtained by copolymerizing compound comprising phenyl groups in the side chains can be exemplified.

Among these, from viewpoints of obtaining relatively high interaction formability with the specific structure polymer and relatively high discrimination of the polymer itself, a novolak resin is preferable. A novolac resin is contained in the photosensitive layer.

As the novolak resin, for instance, a phenol formaldehyde resin, an m-cresol formaldehyde resin, a p-cresol formaldehyde resin, an m-/p-mixture cresol formaldehyde resin or a phenol/cresol (any one of m-, p-, o-, m-/p-mixture, m-/o-mixture and o-/p-mixture may be used) mixture formaldehyde resin can be cited. These may be used singularly or in a combination of at least two kinds.

As the novolak resins preferably used together, ones having a weight average molecular weight of 1500 or more and a number average molecular weight of 300 or more are preferable. Further preferably, a weight average molecular weight is in the range of 3,000 to 300,000, a number average molecular weight is 500 to 250,000, and the degree of dispersion (weight average molecular weight/number average molecular weight) is in the range of 1.1 to 10.

Furthermore, as other compounds having a phenol group, acryl amide, methacryl amide, acrylic acid ester, methacrylic acid ester or hydroxy styrene each having a phenol group can be cited.
(1) Preferable alkali-soluble resins other than alkali-soluble resins having a phenolic hydroxyl group will be described.
(2) As alkali-soluble resins having a sulfone amide group, for instance, polymers that are constituted of a minimum constituent unit as a main component derived from a compound having a sulfone amide group, can be cited. Examples of such a compound include a compound having, in a molecule thereof, at least one sulfone amide group in which at least one hydrogen atom is bound to a nitrogen atom and at least one polymerizable unsaturated group.
   Among these, in the invention, in particular, m-aminosulfonylphenyl methacrylate, N-(p-aminosulfonylphenyl)methacrylamide, N-(p-aminosulfonylphenyl)acrylamide or the like can be preferably used.
(3) Examples of the aqueous alkaline solution-soluble resin having activated imido group is polymers comprising minimum monomer units derived from compounds having activated imido group as main constituent components. Examples of such compounds are compounds having activated imido groups and polymerizable unsaturated groups at least one each in one molecule defined by the following structural formula.

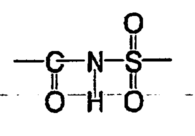

Practically, N-(p-toluenesulfonyl) methacrylamide, and N-(p-toluenesulfonyl) acrylamide are especially preferably used.

Regarding the minimum constituent unit constituting an alkali-soluble resin that is used in a recording layer used in the invention and having an acidic group that is selected from the (1) through (6), there is no need of using only one kind of the minimum constituent group, but at least two kinds of the minimum constituent units having the same acidic group may be copolymerized or at least two kinds of the minimum constituent units having different acidic groups may be copolymerized, as well.

In the copolymer, a content of the compound that is copolymerized therein and has an acidic group selected from the (1) through (6) is preferably 10% by mole or more, and more preferably by 20% by mole or more. When the content is less than 10% by mole, the latitude improvement effect owing to the addition thereof tends to be insufficient.

As the alkali-soluble resins, a homopolymer or a copolymer of a polymerizing monomer having the phenolic hydroxyl group or a polymerizing monomer having an active imide group is preferable. In particular, a homopolymer or a copolymer of polymerizing monomers having a sulfoneamide group such as m-aminosulfonylphenyl methacrylate, N-(p-aminosulfonylphenyl) methacrylamide, N-(p-aminosulfonylphenyl) acrylamide or the like is preferable.

A weight average molecular weight of the alkali-soluble resin is preferably 2,000 or more and a number average molecular weight is preferably 500 or more. More preferably, the weight average molecular weight is in the range of 5,000 to 300,000, the number average molecular weight is in the range of 800 to 250,000, and the degree of dispersion (weight average molecular weight/number average molecular weight) is in the range of 1.1 to 10.

Furthermore, when in the invention the alkali-soluble resin is a resin such as a phenol formaldehyde resin, a cresol aldehyde resin or the like, it is preferable that the weight average molecular weight is in the range of 500 to 20,000 and the number average molecular weight is in the range of 200 to 10,000.

The alkali-soluble resins may be used singularly or in a combination of at least two kinds thereof. The alkali-soluble resin is added, relative to the specific structure polymer in the photosensitive composition, preferably in the range of 1 to 50% by mass, and more preferably in the range of 5 to 30% by mass. Furthermore, from viewpoints of the durability of a film and the sensitivity, a content thereof in the recording layer is, with respect to a total solid content, in the range of 1 to 30% by weight, preferably in the range of 3 to 25% by weight, and particularly preferably in the range of 5 to 20% by mass.

### [Onium Salt]

A recording layer of a planographic printing plate precursor according to the invention necessarily contains an onium salt. The onium salts used in the invention are compounds represented by a formula (A) below.

Formula (A): M⁺X⁻

In the formula (A), the M⁺ represents a cation selected from sulfonium and iodonium, that may have a substituent group. The X⁻ represents an arbitrary counter anion and an organic acid anion is preferable.

In the invention, the onium salt, when mixed with a polymer compound that is water-insoluble and alkali-soluble, works as a dissolution inhibitor that lowers the solubility of the polymer compound to water or an alkaline developer.

In what follows, specific examples of onium salt compounds represented by the formula (A) are exemplified. However, the invention is not restricted to these, and, as far as the scope of the onium salt compound is within the range that is represented by the formula (A), any compound can be selected therefor. * denotes onium salts used as references only

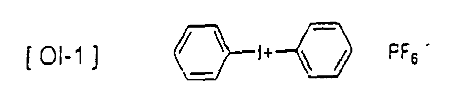

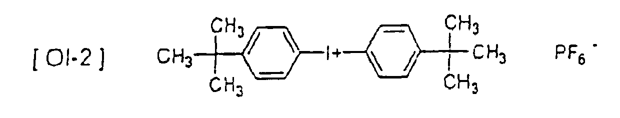

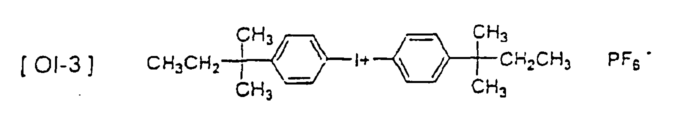

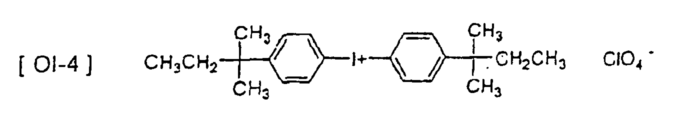

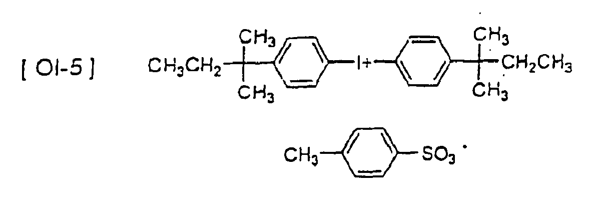

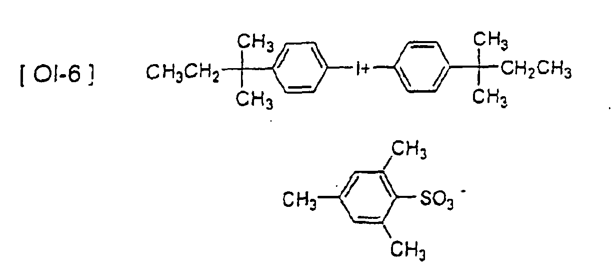

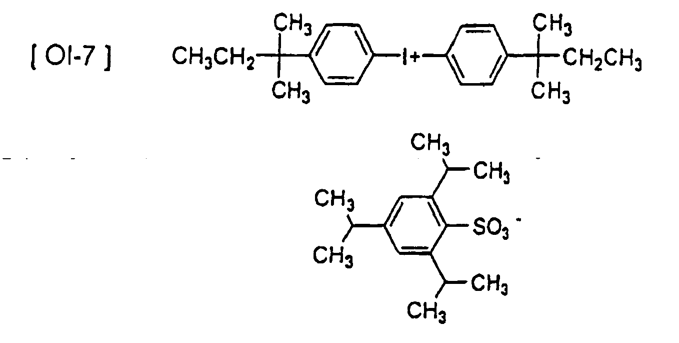

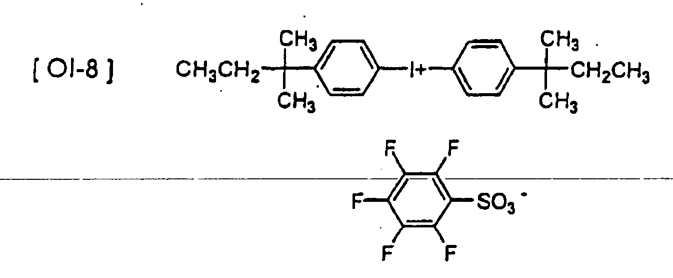

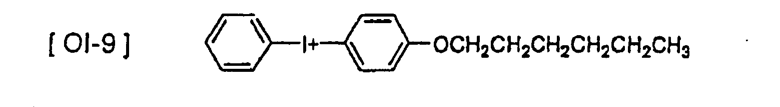

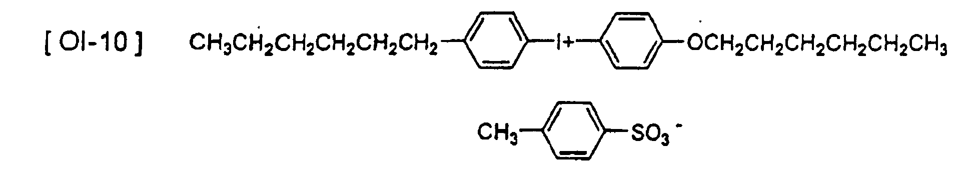

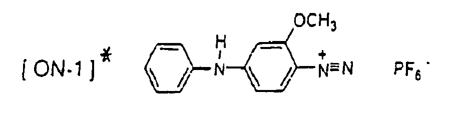

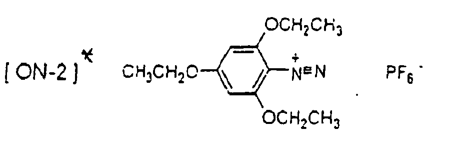

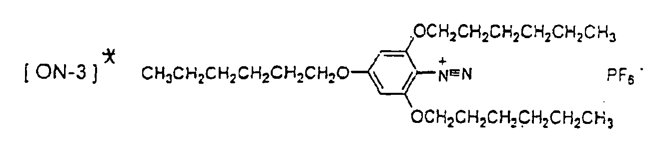

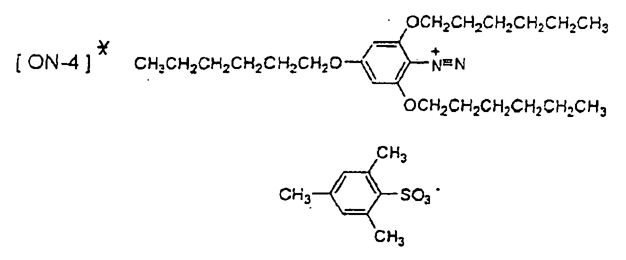

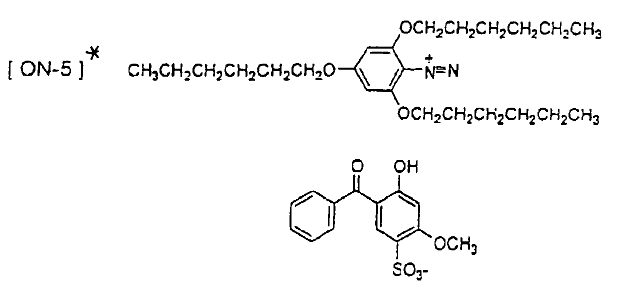

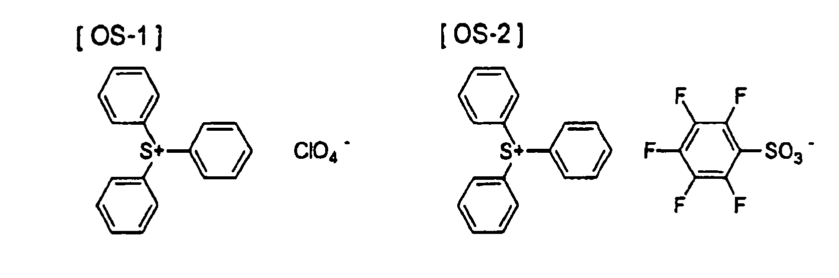

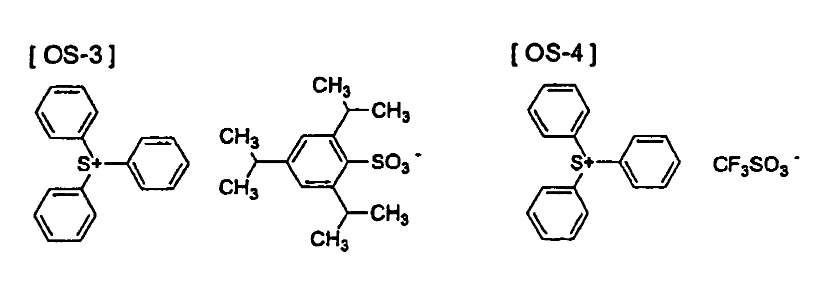

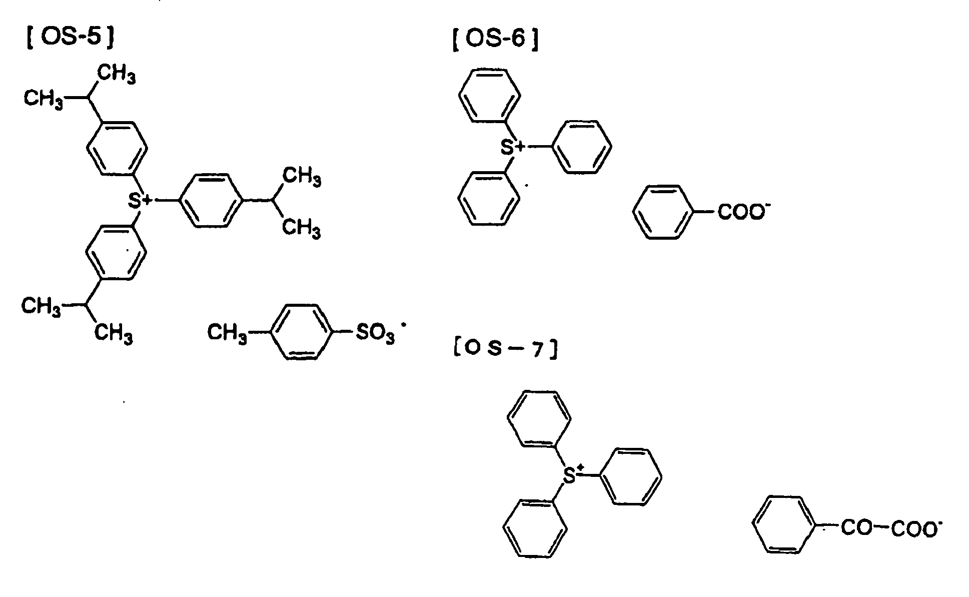

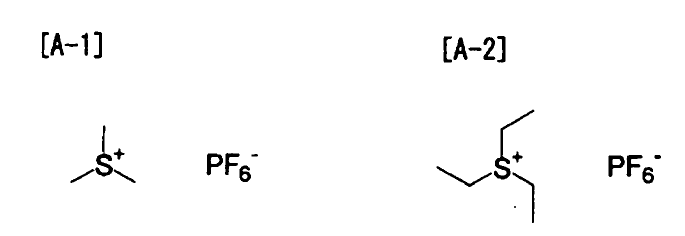

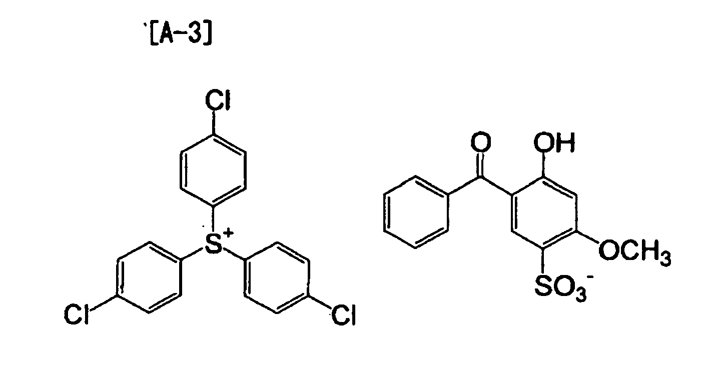

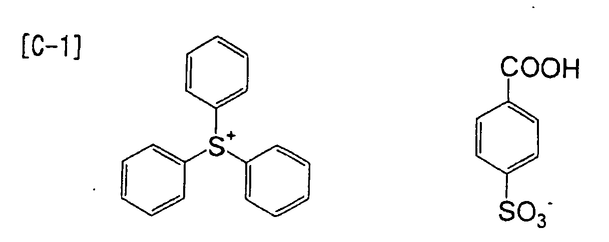

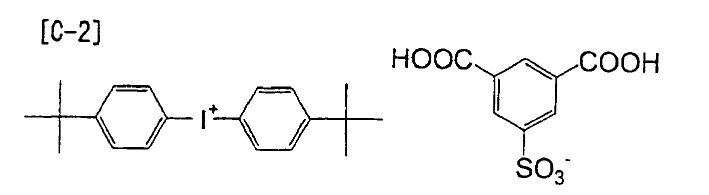

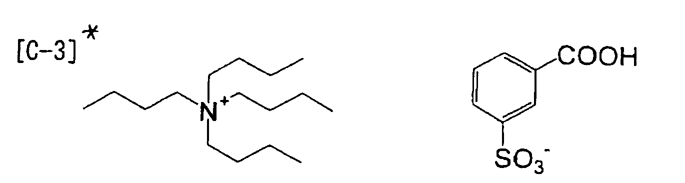

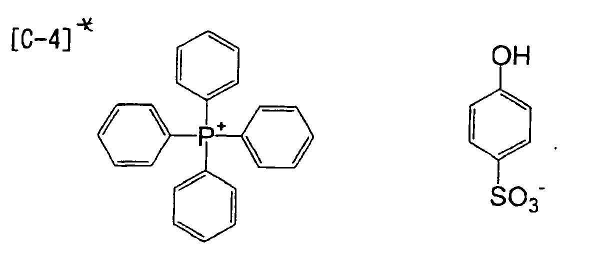

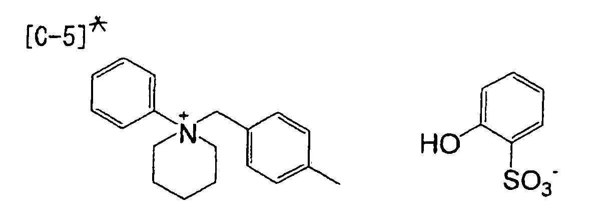

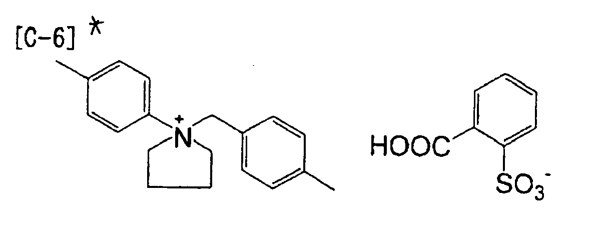

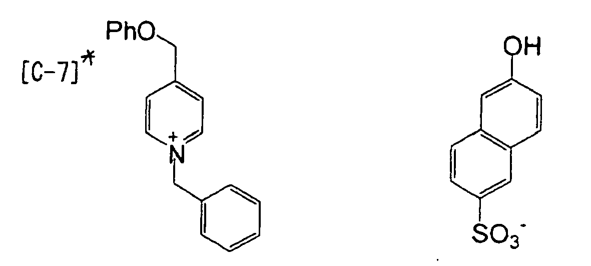

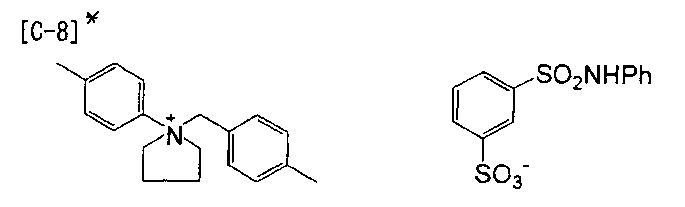

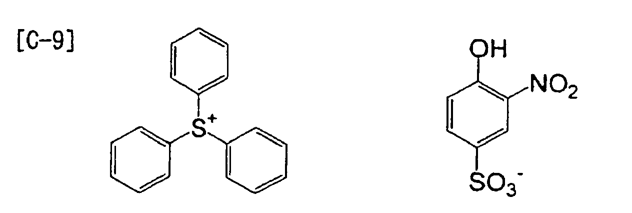

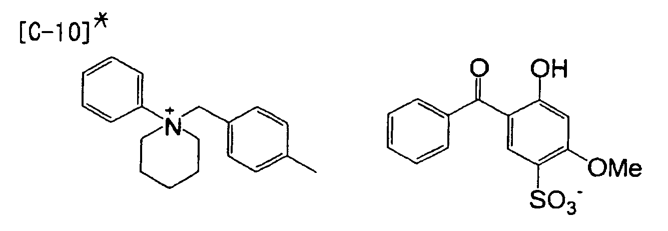

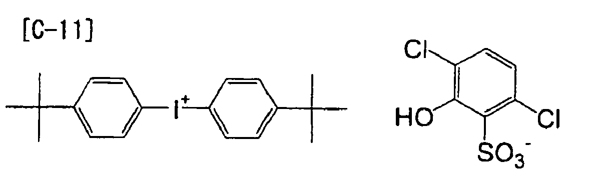

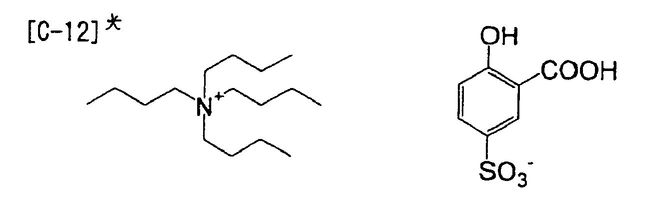

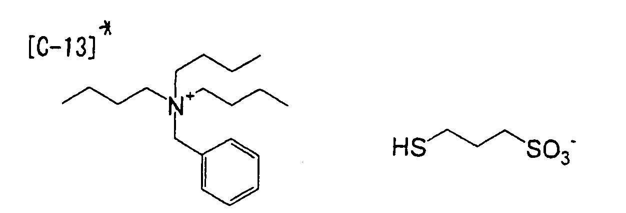

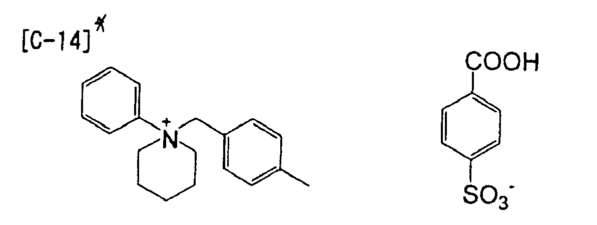

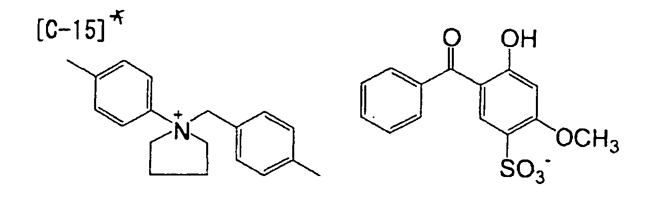

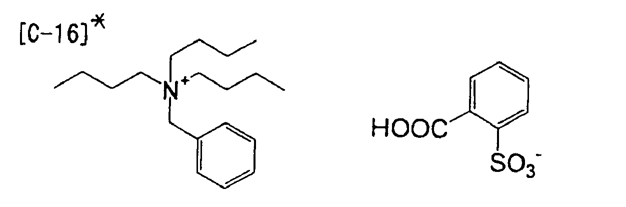

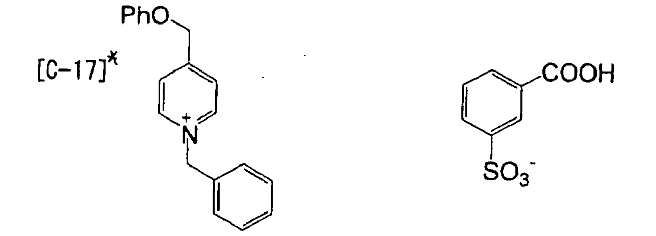

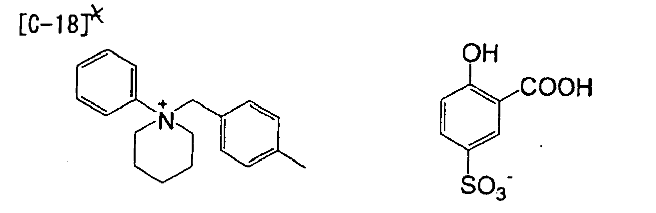

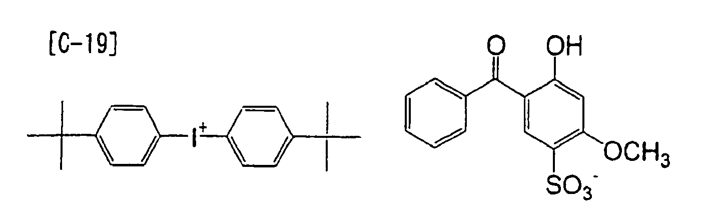

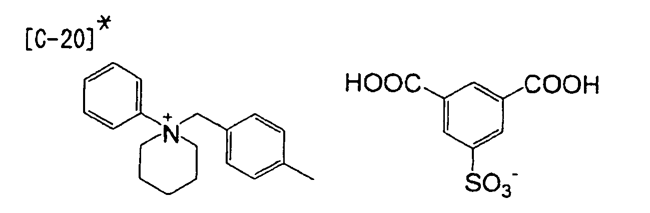

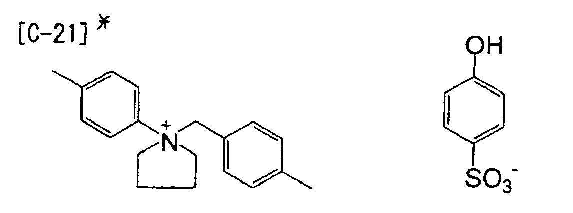

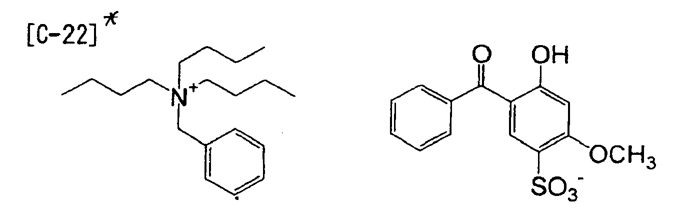

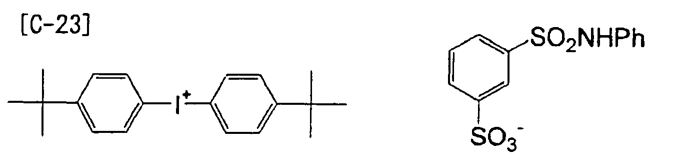

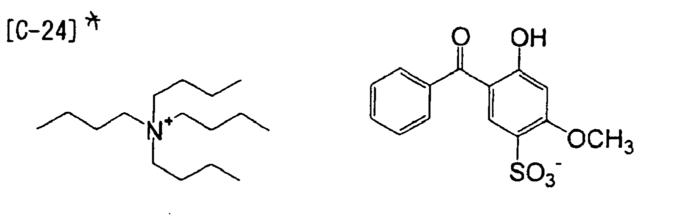

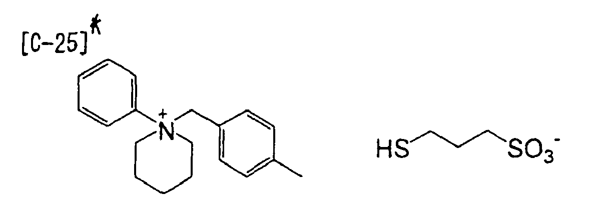

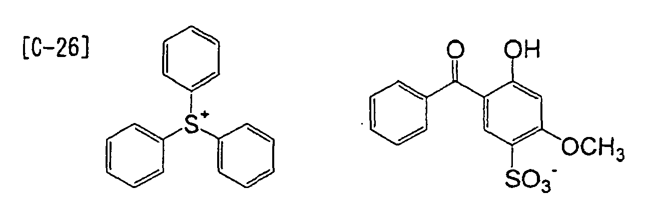

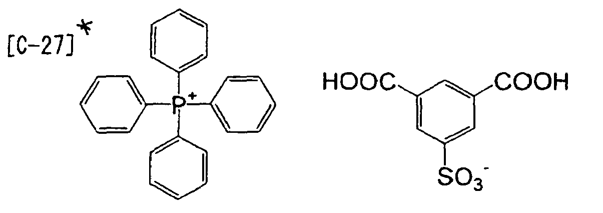

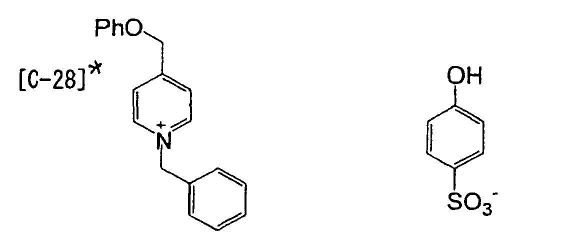

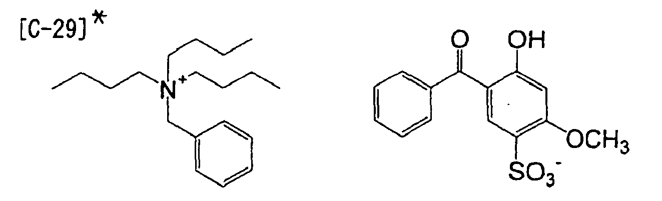

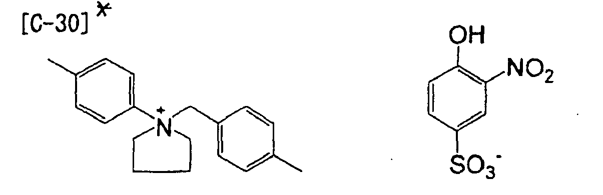

These onium salts may be used singularly or in a combination of at least two kinds. Furthermore, from viewpoints of improving the sensitivity and expanding the development latitude, it is contained, with respect to a total solid content of the recording layer, preferably in the range of 0.1 to 30% by mass and more preferably in the range of 1 to 20% by mass.

### (Infrared Absorber)

An infrared absorber used in the invention represents a substance that has a light absorption region in an infrared region of 700 nm or more, preferably in the range of 750 to 1200 nm and exhibits the photo-thermal conversion capability by the action of light having a wavelength region thereof in the foregoing range. Specifically, various kinds of dyes or pigments that absorb light in the foregoing wavelength region and generate heat can be used.

As a dye, commercially available dyes and the known dyes described in the publication such as "Dye Handbook" (edited by The Society of Synthetic Organic Chemistry, Japan, published in 1970) can be utilized. Examples include dyes such as azo dyes, metal complex salt azo dyes, pyrazolone azo dyes, naphthoquinone dyes, anthraquinone dyes, phthalocyanine dyes, carbonium dyes, quinoneimine dyes, methine dyes, cyane dyes, squarylium pigments, pyrilium salts, metal thiolate complexes, oxomol dyes, diimonium dyes, aminium dyes, and croconium dyes.

Among these dyes, particularly preferable are cyanine dyes, phthalocyanine dyes, oxonol dyes, squarylium dyes, pyrylium salts, thiopyrylium dyes, and nickel thiolate complexes. Cyanine dyes represented by the following general formula (a) are also preferable since such dyes are excellent in terms of photothermal conversion efficiency. The cyanine dyes represented by the following general formula (a) are most preferable for the following reason: when the dyes are used in the recording layer of the planographic printing plate precursor of the invention, the dyes manifest a high degree of interaction with the alkali-soluble resin; and the dyes are also excellent in terms of stability and economy.

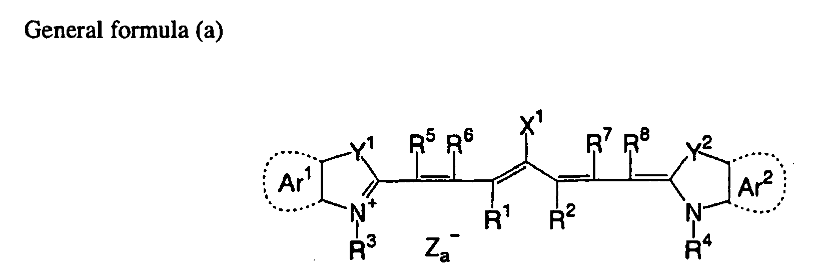

In general formula (a), X¹ represents a hydrogen atom, a halogen atom, -NPh₂, X²-L¹ (wherein X² represents an oxygen atom or a sulfur atom, L¹ represents a hydrocarbon group having 1 to 12 carbon atoms, an aromatic cyclic group having a heteroatom, or a hydrocarbon group containing a heteroatom and having 1 to 12 carbon atoms, and the heteroatom referred to herein is N, S, O, a halogen atom, or Se), or a group represented by the following: 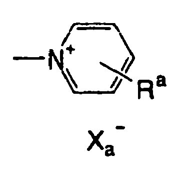 wherein Xa⁻ has the same definition as Za⁻, which will be described at a later time, and R^{a} represents a substituent selected from a hydrogen atom, an alkyl group, an aryl group, a substituted or unsubstituted amino group, or a halogen atom;
R¹ and R² each independently represents a hydrocarbon group having 1 to 12 carbon atoms, and from the viewpoint of the storage stability of the photosensitive composition of the invention when it is used in a coating solution for forming a recording layer of a planographic printing plate precursor, it is preferable that R¹ and R² each independently represents a hydrocarbon group having 2 or more carbon atoms, and more preferably R¹ and R² are bonded to each other to form a 5-membered or 6-membered ring.

Ar¹ and Ar², which may be the same or different, each represent an aromatic hydrocarbon group which may have a substituent. Preferable examples of the aromatic hydrocarbon group include benzene and naphthalene rings. Preferable examples of the substituent include hydrocarbon groups having 12 or less carbon atoms, halogen atoms, and alkoxy groups having 12 or less carbon atoms.

Y¹ and Y², which may be the same or different, each represents a sulfur atom, or a dialkylmethylene group having 12 or less carbon atoms.

R³ and R⁴, which may be the same or different, each represents a hydrocarbon group which has 20 or less carbon atoms and may have a substituent. Preferable examples of the substituent include alkoxy groups having 12 or less carbon atoms, a carboxyl group, and a sulfo group. R⁵, R⁶, R⁷ and R⁸, which may be the same or different, each represents a hydrogen atom, or a hydrocarbon group having 12 or less carbon atoms, and since the raw materials thereof can easily be obtained, each preferably represents a hydrogen atom.

Za⁻ represents a counter anion. However, in a case where the cyanine dye represented by general formula (a) has an anionic substituent in the structure thereof and there is accordingly no need to neutralize electric charges in the dye, Za⁻ is not required. From the viewpoint of the storage stability of the recording layer coating solution, Za⁻ is preferably an ion of a halogen, perchlorate, tetrafluroborate, hexafluorophosphate, carboxylate or sulfonate. From the viewpoints of compatibility of the dye with the alkali-soluble resin and solubility in the coating solution, Za⁻ is preferably a halogen ion, or an organic acid ion such as a carboxylic acid ion or sulfonic acid ion, more preferably a sulfonic acid ion, and even more preferably an arylsulfonic acid ion.

Specific examples of the cyanine dye represented by general formula (a), and which can be preferably used in the invention, include dyes in JP-A No. 2001-133969 (paragraphs [0017] to [0019]), JP-A No. 2002-40638 (paragraphs [0012] to [0038]), and JP-A No. 2002-23360 (paragraphs [0012] to [0023]), as well as dyes illustrated below.

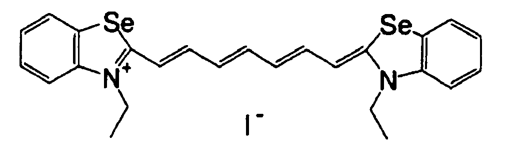

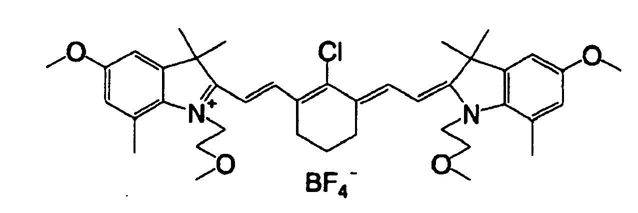

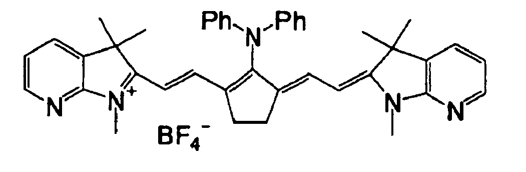

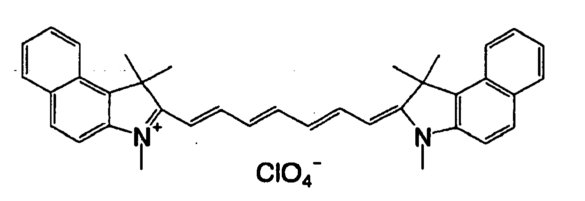

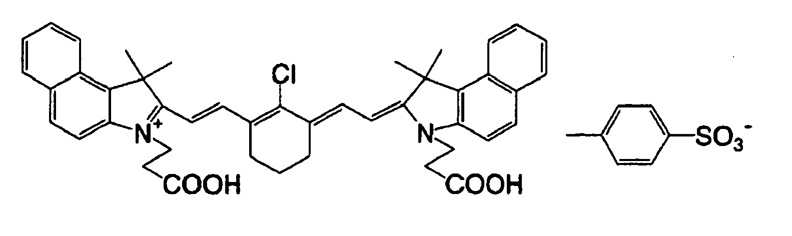

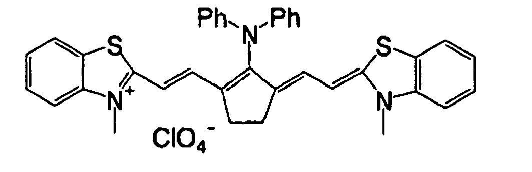

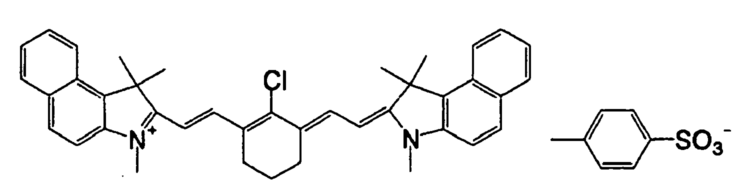

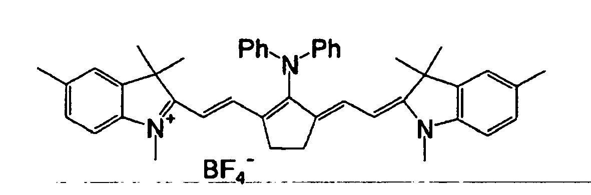

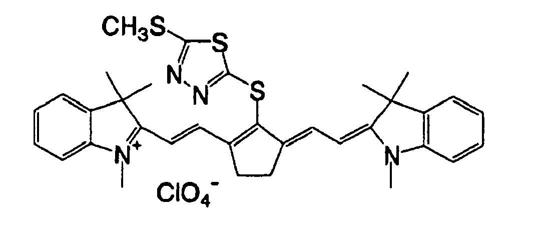

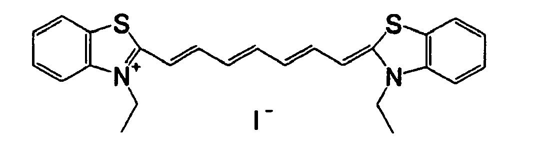

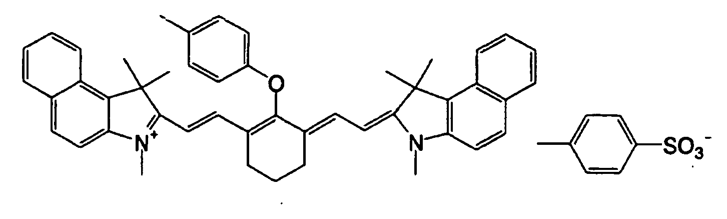

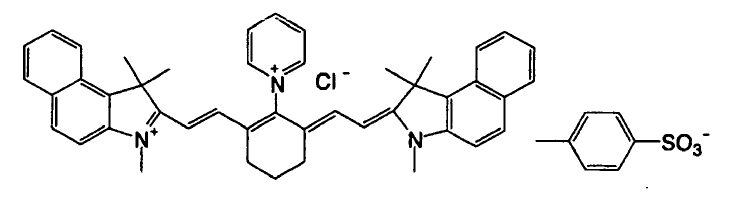

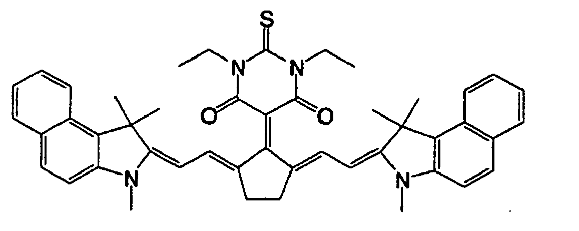

As other preferable dyes, for instance, cyanine dyes described in Japanese Patent Application Laid-Open (JP-A) Nos. 58-125246, 59-84356, 59-202829 and 60-78787; methyne dyes described in JP-A Nos. 58-173696, 58-181690 and 58-194595; naphthoquinone dyes described in JP-A Nos. 58-112793, 58-224793, 59-48187, 59-73996, 60-52940 and 60-63744; squarylium dyes described in JP-A No. 58-112792; and cyanine dyes described in U. K. Patent No. 434,875 can be cited.

Furthermore, near-infrared absorbing sensitizers described in USP No. 5,156,938 can be preferably used. Still furthermore, arylbenzo(thio)pyrilium salts described in USP No. 3,881,924; trimethine thiapyrilium salts described in JP-A No. 57-142645 (USP No. 4,327,169); pyrilium base compounds described in JP-A Nos. 58-181051, 58-220143, 59-41363, 59-84248, 59-84249, 59-146063 and 59-146061; cyanine dyes described in JP-A No. 59-21646; pentamethine thiopyrilium salts described in USP No. 4,283,475; and pyrilium compounds described in Japanese Patent Application Publication (JP-B) Nos. 5-13514 and 5-19702 can be preferably used as well.

Furthermore, as other examples preferable as dyes, infrared absorbing dyes described as formulas (I) and (II) in a specification of USP No. 4,756,993 can be cited.

The pigment used as the infrared absorbent in the invention may be a commercially available pigment or a pigment described in publications such as Color Index (C.I.) Handbook, "Latest Pigment Handbook" (edited by Japan Pigment Technique Association, and published in 1977), "Latest Pigment Applied Technique" (by CMC Publishing Co., Ltd. in 1986), and "Printing Ink Technique" (by CMC Publishing Co., Ltd. in 1984).

Examples of the pigment include black pigments, yellow pigments, orange pigments, brown pigments, red pigments, purple pigments, blue pigments, green pigments, fluorescent pigments, metal powder pigments, and polymer-bonded dyes. Specifically, the following can be used: insoluble azo pigments, azo lake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, dyeing lake pigments, azine pigments, nitroso pigments, nitro pigments, natural pigments, fluorescent pigments, inorganic pigments, and carbon black.

The particle size of the pigment is preferably from 0.01 to 10 µm, and in terms of stability of the pigments dispersed in a coating solution and even distribution of the pigments in the recording layer, more preferably from 0.05 to 1 µm, more preferably from 0.05 to 1 µm and even more preferably from 0.1 to 1 µm.

The method for dispersing the pigment may be a known dispersing technique used to produce ink or toner. Examples of a dispersing machine, which can be used, include an ultrasonic disperser, a sand mill, an attriter, a pearl mill, a super mill, a ball mill, an impeller, a disperser, a KD mill, a colloid mill, a dynatron, a three-roll mill, and a pressing kneader. Details are described in "Latest Pigment Applied Technique" (by CMC Publishing Co., Ltd. in 1986).

The pigments or dyes are added, from viewpoints of the sensitivity and the uniformity and durability of the recording layer, relative to a total solid content that constitutes a top layer of the recording layer, in the range of 0.01 to 50% by mass and preferably in the range of 0.1 to 10% by mass. In particular, in the case of the dye, it is preferably contained at a ratio in the range of 0.5 to 10% by mass, and in the case of the pigment it is preferably contained at a ratio in the range of 0.1 to 10% by mass.

### (Other Ingredients)

To the recording layer used in the invention, as need arises, various kinds of additives may be further added.

For instance, in order to control the solubility, so-called dissolution inhibitors such as an aromatic sulfone compound, an aromatic sulfonic acid ester compound and a poly-functional amine compound that improve, when added, the dissolution inhibiting function of an alkaline aqueous solution-soluble polymer (alkali-soluble resin) to a developer can be preferably added. Among these, from a viewpoint of improving the dissolution inhibiting property of an image portion to the developer, a substance such as an o-quinonediazido compound or a sulfonic acid alkyl ester that is pyrolizable and, in a state where it is not decomposed, can substantially lowers the solubility of the alkali-soluble resin can be preferably used together.

The quinonediazide is preferably an o-quinonediazide compound. The o-quinonediazide compound used in the invention is a compound having at least one o-quinonediazide group and having an alkali-solubility increased by being thermally decomposed. The compound may be any one of compounds having various structures.

In other words, the o-quinonediazide compound assists the solubility of the photosensitive material both from the viewpoint of the effects of being thermally decomposed, and thereby losing the function of suppressing the dissolution of the binder, and the effect that the o-quinonediazide itself is changed into an alkali-soluble material.

Preferable examples of the o-quinonediazide compound used in the invention include compounds described in J. Coser, "Light-Sensitive Systems" (John Wiley & Sons. Inc.), pp. 339-352. Particularly preferable are sulfonic acid esters or sulfonamides of o-quinonediazide made to react with various aromatic polyhydroxy compounds or with aromatic amino compounds.

Further preferable examples include an ester made from benzoquinone-(1,2)-diazidesulfonic acid chloride or naphthoquinone-(1,2)-diazide-5-sulfonic acid chloride and pyrogallol-acetone resin, as described in JP-B No. 43-28403; and an ester made from benzoquinone-(1,2)-diazidesulfonic acid chloride or naphthoquinone-(1,2)-diazide-5-sulfonic acid chloride and phenol-formaldehyde resin described in US 3,046,120 and US 3,188, 210.

The amount of the o-quinonediazide compound to be added as an inhibitor of decomposition-based dissolution is preferably in a range from 1 to 10 mass%, more preferably in a range from 1 to 5 mass% and particularly preferably in a range from 1 to 2 mass% based on the total solid content of each recording layer. These compounds may be used as a mixture of plural types, although each may be used singly.

The amount of the additives other than o-quinonediazide compound is preferably 0.1 to 5 mass%, more preferably 0.1 to 2 mass% and particularly preferably 0.1 to 1.5 mass%. The additives and binder used in the invention are preferably compounded in the same layer.

Furthermore, a dissolution inhibitor that does not have the decomposition property can be used together. As preferable dissolution inhibitors, a sulfonic acid ester, a phosphoric acid ester, an aromatic carboxylic acid ester, an aromatic disulfone, a carboxylic anhydride, an aromatic ketone, an aromatic aldehyde, an aromatic amine and an aromatic ether described in JP-A No. 10-268512; an acid-coloring dye having a lactone structure, an N,N-diarylamide structure or a diarylmethylimino structure, working also as a coloring agent, and described in JP-A No. 11-190903; and a nonionic surfactant described in JP-A No. 2000-105454 can be cited.

Furthermore, as additives used in the recording layer used in the invention, cyclic acid anhydrides, phenols and organic acids that are added to improve the sensitivity can be cited. Furthermore, a surfactant, an image coloring agent and a plasticizer, described later, can be added to the recording layer used in the invention.

A ratio of the cyclic acid anhydride, phenols and organic acids in the recording layer is preferably in the range of 0.05 to 20% by mass, more preferably in the range of 0.1 to 15% by mass and most preferably in the range of 0.1 to 10% by mass.

Furthermore, in addition to the compounds described above, an epoxy compound; vinyl ethers; furthermore, a phenol compound described in JP-A No. 8-276558 and having a hydroxymethyl group; a phenol compound having an alkoxymethyl group; and a cross-linkable compound having a alkali-dissolution inhibiting property and described in JP-A No. 11-160860 formerly proposed by the inventors can be appropriately added in accordance with an object.

In the image recording layer of the planographic printing plate precursor of the invention, in order to enhance stability in processes which affect conditions of developing, the following can be added: nonionic surfactants as described in JP-A Nos. 62-251740 and 3-208514; amphoteric surfactants as described in JP-A Nos. 59-121044 and 4-13149; siloxane compounds as described in EP No. 950517; and copolymers made from a fluorine-containing monomer as described in JP-A No. 11-288093.

The content of the nonionic surfactant and/or the amphoteric surfactant in the photosensitive composition is preferably from 0.05 to 15 % by mass, and more preferably from 0.1 to 5% by mass.

To the photosensitive composition of the invention may be added a printing-out agent for obtaining a visible image immediately after the photosensitive composition of the invention has been heated by exposure to light, or a dye or pigment as an image coloring agent.

A typical example of a printing-out agent is a combination of a compound which is heated by exposure to light, thereby emitting an acid (an optically acid-generating agent), and an organic dye which can form salts (salt formable organic dye).

Specific examples thereof include combinations of an o-naphthoquinonediazide-4-sulfonic acid halogenide with a salt-formable organic dye, described in JP-A Nos. 50-36209 and 53-8128; and combinations of a trihalomethyl compound with a salt-formable organic dye, described in each of JP-A Nos. 53-36223, 54-74728, 60-3626, 61-143748, 61-151644 and 63-58440.

The trihalomethyl compound is classified into an oxazol compound or a triazine compound. Both of the compounds provide excellent in stability over the passage of time and produce a vivid printed-out image.

As the image coloring agent, a dye different from the above-mentioned salt-formable organic dye may be used. Preferable examples of such a dye (and the above-mentioned salt-formable organic dye) include oil-soluble dyes and basic dyes.

Specific examples thereof include Oil yellow #101, Oil Yellow #103, Oil Pink #312, Oil Green BG, Oil Blue BOS, Oil Blue #603, Oil Black BY, Oil Black BS, and Oil Black T-505 (each of which is manufactured by Orient Chemical Industries Ltd.); Victoria Pure Blue, Crystal Violet (CI42555), Methyl Violet (CI42535), Ethyl Violet, Rhodamine B (CI145170B), Malachite Green (CI42000), and Methylene Blue (CI52015).

Dyes described in JP-A No. 62-293247 are particularly preferable. These dyes may be added to the photosensitive composition at a ratio of 0.01 to 10% by mass, and preferably 0.1 to 3% by mass, relative to the total solid contents therein.

Whenever necessary, a plasticizer may be added to the photosensitive composition constituting the recording layer of the invention, to give flexibility to a coating film made from the composition. Examples of the plasticizer include oligomers and polymers of butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl olete, and acrylic acid and methacrylic acid.

### [Planographic Printing Plate Precursor]

In what follows, preferable aspects of a planographic printing plate precursor according to the invention having the foregoing recording layer will be described.

### [Layer Configuration]

A layer configuration of a recording layer in a planographic printing plate precursor according to the invention is optional and can take any one of a single layer structure, a phase separation structure and a multi-layer structure. However, a single layer structure and a phase separation structure are preferably taken.

When the recording layer takes the phase separation structure, the photosensitive composition characteristic of the invention may be used either in a matrix (dispersing medium phase) and a dispersion phase of the phase separation structure.

### [Formation of Recording Layer]

In the planographic printing plate precursor according to the invention, the photosensitive composition is dissolved in a solvent, coated on an appropriate substrate, and dried to form a recording layer.

Examples of the solvent to be used for the coating solution include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propylacetate, dimethoxyethane, methyl lactate, ethyl lactate, N,N-dimethylacetamide, N,N-dimethylformamide, tetramethylurea, N-methylpyrrolidone, dimethyl sulfoxide, sulflan, γ-butyrolactone, toluene, and the like. without being limited to these examples. These solvents are used alone or in form of mixtures. The concentration of the above-mentioned components (in total solid matters including additives) in the solvent is preferably 1 to 50% by mass.

A coating amount (solid content) of the recording layer on the substrate, which is obtained after coating and drying, although it varies depending on applications, is generally preferably in the range of 0.5 to 5.0 g/m² for a single layer structure. Furthermore, as a bottom layer in the multi-layer structure, 0.1 to 5.0 g/m² is preferable and 0.2 to 3.0 g/m² is more preferable. As a top layer (the uppermost layer), an amount in the range of 0.01 to 5.0 g/m² is preferable and an amount in the range of 0.05 to 2.0 g/m² is more preferable. As the coating amount is smaller, although apparent sensitivity is larger accordingly, the film characteristics of the recording layer may be deteriorated.

As a method of coating a recording layer coating solution, various methods can be used. For instance, a bar coating method, a rotation coating method, a spray coating method, a curtain coating method, a dip coating method, an air-knife coating method, a blade coating method and a roll coating method can be cited.

When a recording layer is formed into a multi-layer structure, examples of the method of forming two layers (top layer and bottom layer) separately include a method which makes use of difference in solvent solubility of components between the bottom layer and the top layer and a method where a top layer is first coated, followed by rapidly drying and removing the solvent therefrom.

Furthermore, in the recording layer used in the invention, a surfactant for improving the coating property such as a fluorinated surfactant described for instance in JP-A No. 62-170950 can be added. A preferable amount added is, with respect to the total solid content in the recording layer, in the range of 0.01 to 1 % by mass, and more preferably in the range of 0.05 to 0.5% by mass.

### [Support]

The support which is used in the planographic printing plate precursors of the invention may be any plate-form product that has necessary strength and endurance and is dimensionally stable. Examples thereof include a paper sheet; a paper sheet on which a plastic (such as polyethylene, polypropylene, or polystyrene) is laminated; a metal plate (such as an aluminum, zinc, or copper plate), a plastic film (such as a cellulose diacetate, cellulose triacetate, cellulose propionate, cellulose lactate, cellulose acetate lactate, cellulose nitrate, polyethylene terephthalate, polyethylene, polystyrene, polypropylene, polycarbonate, or polyvinyl acetal film); and a paper or plastic film on which a metal as described above is laminated or vapor-deposited.

Of these supports, a polyester film or an aluminum plate is preferable in the invention. An aluminum plate is particularly preferable since the plate is good in dimensional stability and relatively inexpensive. Preferable examples of the aluminum plate include a pure aluminum plate, and alloy plates comprising aluminum as the main component and a small amount of different elements. A plastic film on which aluminum is laminated or vapor-deposited may be used. Examples of the different elements contained in the aluminum alloy include silicon, iron, manganese, copper, magnesium, chromium, zinc, bismuth, nickel, and titanium. The content by percentage of the different elements in the alloy is at most 10% by mass.

In the invention, pure aluminum is particularly preferable. However, completely pure aluminum is not easily produced from the viewpoint of metallurgy technology. Thus, aluminum containing a trance amount of the different elements may be used.

As described above, the aluminum plate used in the invention, the composition of which is not specified, may be any aluminum plate that has been known or used hitherto. The thickness of the aluminum plate used in the invention is generally from about 0.1 to 0.6 mm, preferably from 0.15 to 0.4 mm, and more preferably from 0.2 to 0.3 mm.

Such an aluminum plate is generally subjected to surface roughening treatment in order to enhance adhesion to a recording layer provided thereon. Before the surface of the aluminum plate is roughened, the plate is subjected to degreasing treatment with a surfactant, an organic solvent, an aqueous alkaline solution or the like if desired, in order to remove rolling oil on the surface. The roughening treatment of the aluminum plate surface is performed by any one of various methods, for example, by a mechanically surface-roughening method, or a method of dissolving and roughening the surface electrochemically, or a method of dissolving the surface selectively in a chemical manner.

The mechanically surface-roughening method which can be used may be a known method, such as a ball polishing method, a brush polishing method, a blast polishing method or a buff polishing method. The electrochemically surface-roughening method may be a method of performing surface-roughening in a hydrochloric acid or nitric acid electrolyte by use of alternating current or direct current. As disclosed in JP-A No. 54-63902, a combination of the two may be used.

The aluminum plate the surface of which is roughened as described above is subjected to alkali-etching treatment and neutralizing treatment if necessary. Thereafter, the aluminum plate is subjected to anodizing treatment if desired, in order to improve the water holding ability or wear resistance of the surface. The electrolyte used in the anodizing treatment of the aluminum plate is any one selected from various electrolytes which can make a porous oxide film. There is generally used sulfuric acid, phosphoric acid, oxalic acid, chromic acid, or a mixed acid thereof. -The concentration of-the electrolyte may be appropriately decided dependently on the kind of the electrolyte.

Conditions for the anodizing treatment cannot be specified without reservation since the conditions vary dependently on the used electrolyte. The following conditions are generally suitable: an electrolyte concentration of 1 to 80% by mass, a solution temperature of 5 to 70°C, a current density of 5 to 60 A/dm², a voltage of 1 to 100 V, and an electrolyzing time of 10 seconds to 5 minutes. If the amount of the anodic oxide film is less than 1.0 g/m², the printing durability is insufficient or non-image areas of the planographic printing plate are easily injured so that the so-called "injury stains", resulting from ink adhering to injured portions at the time of printing, are easily generated.

If necessary, the aluminum surface is subjected to treatment for hydrophilicity after the anodizing treatment.

The treatment for hydrophilicity which can be used in the invention may be an alkali metal silicate (for example, aqueous sodium silicate solution) method, as disclosed in USP Nos. 2,714,066, 3,181,461, 3,280,734, and 3,902,734. In this method, the support is subjected to immersing treatment or electrolyzing treatment with aqueous sodium silicate solution. Besides, there may be used a method of treating the support with potassium fluorozirconate disclosed in JP-B No. 36-22063 or with polyvinyl phosphonic acid, as disclosed in USP Nos. 3,276,868, 4,153,461, and 4,689,272.

### [Undercoat Layer]

In the planographic printing plate precursor according to the invention, on a substrate, a recording layer containing the specific structure polymer is disposed. However, as need arises, between the substrate and the bottom layer of the recording layer, an undercoat layer may be disposed.

When the undercoat layer is disposed, since the undercoat layer between the substrate and the recording layer works as a heat insulating layer, heat generated by exposing to infrared laser can be efficiently used without diffusing to the substrate, resulting in advantageously obtaining high sensitivity. Furthermore, since the recording layer used in the invention is, even when the undercoat layer is disposed, located on an exposure surface or in the vicinity thereof, the sensitivity to the infrared laser can be maintained excellent.

Furthermore, in an unexposed portion, it is considered that since an image recording layer itself that is impermeable to the alkaline developer works as a protective layer of the undercoat layer, the development stability is excellent and an image excellent in the discrimination can be formed. Further, the stability with a lapse of time can also be secured in the unexposed portion.

As components for the undercoat layer, various organic compounds may be used. Examples thereof include carboxymethylcellulose, dextrin, gum arabic, phosphonic acids having an amino group such as 2-aminoethylphosphonic acid, organic phosphonic acids such as phenylphosphonic acid, naphthylphosphonic acid, alkylphosphonic acid, glycerophosphonic acid, methylenediphosphonic acid and ethylenediphosphonic acid, each of which may have a substituent, organic phosphoric acids such as phenylphosphoric acid, naphthylphosphoric acid, alkylphosphoric acid and glycerophosphoric acid, each of which may have a substituent, organic phosphinic acids such as phenylphosphinic acid, naphthylphosphinic acid, alkylphosphinic acid, and glycerophosphinic acid, each of which may have a substituent, amino acids such as glycine and β-alanine, and hydrochlorides of amines having a hydroxyl group, such as hydrochloride of triethanolamine. These may be used in a mixture form.

Still furthermore, an undercoat layer containing at least one kind of compound selected from a group of organic polymer compounds having a structural unit represented by a formula below is preferable, as well.

This organic undercoat layer can be formed by the following method: a method of dissolving the above-mentioned organic compound into water, an organic solvent such as methanol, ethanol or methyl ethyl ketone, or a mixed solvent thereof to prepare a solution, applying the solution onto an aluminum plate, and drying the solution to form the undercoat layer; or a method of dissolving the above-mentioned organic compound into water, an organic solvent such as methanol, ethanol or methyl ethyl ketone, or a mixed solvent thereof to prepare a solution, dipping an aluminum plate into the solution to cause the plate to adsorb the organic compound, washing the plate with water or the like, and then drying the plate to form the undercoat layer.

In the former method, the solution of the organic compound having a concentration of 0.005 to 10% by mass can be applied by various methods. In the latter method, the concentration of the organic compound in the solution is from 0.01 to 20% by mass, preferably from 0.05 to 5% by mass, the dipping temperature is from 20 to 90°C, preferably from 25 to 50°C, and the dipping time is from 0.1 second to 20 minutes, preferably from 2 seconds to 1 minute.

The pH of the solution used in this method can be adjusted into the range of 1 to 12 with a basic material such as ammonia, triethylamine or potassium hydroxide, or an acidic material such as hydrochloric acid or phosphoric acid. A yellow dye can be added to the solution in order to improve the reproducibility of the tone of the image recording material.

The coated amount of the organic undercoat layer is suitably appropriately from 2 to 200 mg/m², and preferably from 5 to 100 mg/m², in terms of obtaining sufficient printing durability.

In a planographic printing plate precursor according to the invention, an image is formed by heat. Specifically, direct imagewise recording with a thermal recording head, scanning exposure with an infrared laser, high brightness flash exposure with a xenon discharge lamp or infrared lamp exposure can be used; however, a solid high-output infrared laser such as a semiconductor laser or a YAG laser that radiates infrared rays in a wavelength of 700 to 1200 nm is preferably used to expose.

An output of the laser is preferably 100 mW or more. In order to shorten an exposure time, a multi-beam laser device can be preferably used. Furthermore, an exposure time per a pixel is preferably 20 µsec or less, and energy illuminated on a recording material is preferably in the range of 10 to 500 mJ/cm².

After the exposure process, the planographic printing plate precursor of the invention has the non-image regions thereof removed by development, to become a planographic printing plate. The developing solution which may be applied to the developing treatment of the planographic printing plate precursor of the invention is a developing solution having a pH range from 9.0 to 14.0 and preferably a pH range from 12.0 to 13.5. As the developing solution (hereinafter referred to as a developing solution including a replenishing solution), a conventionally known aqueous alkali solution may be used.

Examples of the alkali agent include inorganic alkali salts such as sodium silicate, potassium silicate, trisodium phosphate, tripotassium phosphate, triammonium phosphate, disodium hydrogenphosphate, dipotassium hydrogenphosphate, diammonium hydrogenphosphate, sodium carbonate, potassium carbonate, ammonium carbonate, sodium hydrogencarbonate, potassium hydrogencarbonate, ammonium hydrogen carbonate, sodium borate, potassium borate, ammonium borate, sodium hydroxide, ammonium hydroxide, potassium hydroxide and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

These alkali agents may be used alone or in combinations of two or more thereof.

Among the above aqueous alkali solutions, one developer which exerts the effect of the invention is an aqueous solution of a pH 12 or higher so-called "silicate developer" containing alkali silicate as a base, or containing alkali silicate obtained by mixing a base with a silicon compound, and the other more preferable developer is a so-called "non-silicate developer" which does not contain alkali silicate, and contains a non-reducing sugar (organic compound having buffering action) and a base.

In the former, developability of an aqueous solution of alkali metal silicate can be regulated by a ratio (generally expressed by mole ratio of [SiO₂]/[M₂O]) of silicon oxide SiO₂ and alkali metal oxide M₂O. For example, an aqueous solution of sodium silicate in which a mole ratio of SiO₂/Na₂O is 1.0 to 1.5 (that is,[SiO₂]/[Na₂O] is 1.0 to 1.5), and a content of SiO₂ is 1 to 4% by mass as disclosed in JP-A No. 54-62004; and an aqueous solution of alkali metal silicate in which [SiO₂]/[M] is 0.5 to 0.75 (that is, [SiO₂]/[M₂O] is 1.0 to 1.5), a concentration of SiO₂ is 1 to 4% by mass, and the developer contains at least 20% potassium -using gram atom of a total alkali metal present therein as a standard, as described in Japanese Patent Application Publication (JP-B) No. 57-7427are preferably used.

In order to enhance or inhibit the developability, to disperse development scum, or to enhance the ink affinity of a printing plate image portion, as need arises, various kinds of surfactants and organic solvents can be added to the developer and replenisher. As the surfactant, anionic, cationic, nonionic and amphoteric surfactants are preferable. Furthermore, in the developer and replenisher, as need arises, hydroquinone, resorcin, reducing agents such as sodium and potassium salts of an inorganic acid such as sulfurous acid or hydroacid sulfite, further an organic carboxylic acid, a defoaming agent and a hard water softener can be added.

The planographic printing plate developed with the developer and replenisher is post-processed with washing water, a rinse solution containing a surfactant or a desensitizing solution containing gum Arabic and a starch derivative. As the post-processing, the processes can be variously combined and used.

In the case of carrying out development by using an automatic developing apparatus, it is known that a large quantity of PS plates can be treated without replacing the developer in a developer tank for a long duration by adding, to the developer, aqueous solution (a replenisher) with a higher alkalinity than that of the developer. In the invention, this replenishing method is preferably employed. To promote or suppress the developability of the developer or the replenisher and improve the dispersion of development scum and affinity of the image forming portion of the printing plate to ink, a variety of surfactants and organic solvents may optionally be added.

As preferable surfactants, anionic, cationic, nonionic and amphoteric surfactants can be exemplified. Further, to the developer or the replenisher, reducing agents of such as hydroquinone, resorcin, sodium salt or potassium salt of inorganic acids such as sulfurous acid, hydrogen sulfurous acid, and further organic carboxylic acid, defoaming agents, and water hardening or softening agents may be added.

The printing plate treated by using the developer or the replenisher is washed with water and post-treated with rinsing solutions containing the surfactants or the like, and desensitizing solutions containing gum arabic and starch derivatives. The post-treatment of the image recording material of the invention can be carried out by using these treatments in combinations.

Recently, for rationalization or standardization of the printing plate production work in printing plate-producing or printing industries, automatic developing apparatuses for printing plates have been used widely. An automatic developing apparatuses generally comprise a development section and a post-treatment section. More specifically, an automatic developing apparatus includes a unit for transferring the printing plates, tanks for respective treatment solutions, and a spraying apparatuse. The automatic developing apparatus transfers the exposed printing plates horizontally and at the same time carries out development treatment by spraying the respective treatment-solutions pumped up by pumps, to the printing plate, through spray nozzles. Recently, there is also known a method for carrying out treatment by transporting the printing plates by under-solution guide rolls while the printing plates are immersed in the treatment solution tanks filled with the treatment solutions. In such automatic treatment, the replenishers may be replenished to the respective treatment solutions depending on the treatment quantity, operation times, and the like. Alternatively, so-called disposable treatment method in which treatment is carried out using substantially unused treatment solutions can be employed.

In the invention, the planographic printing plate precursor is imagewise exposed, developed, washed with water and/or rinsed and/or gum-coated to obtain a planographic printing plate. If unnecessary image portions (e.g. film edge trace of a master film) are present in the planographic printing plate, the unnecessary image portions are erased. Such erasing is preferably carried out by a method of applying an erasing solution as described in JP-B No. 2-13293 to the unnecessary image portions and washing with water after a prescribed duration. A method of radiating the unnecessary image portions with active light beam led through optical fibers and then carrying out development, as is disclosed in JP A No. 59-174842, may also be employed.

The planographic printing plate produced in such a manner is coated with a desensitizing gum if necessary and supplied to printing steps. In a case where a planographic printing plate with further improved printing durability is to be obtained, burning treatment is optionally carried out.

In the case where the burning treatment of the planographic printing plate is carried out, it is preferable to treat, prior to the burning treatment, the planographic printing plate with surface conditioning solutions described in JP-B Nos. 61-2518 and 55-28062 and JP-A Nos. 62-31859 and 61-159655.

Examples of a method for effecting such a pre-burning treatment include a method of applying the surface conditioning solutions to the planographic printing plate by sponge or degreased cotton doped with the solutions, a method of immersing the printing plate in a vat filled with the surface conditioning solutions, a method of applying the surface conditioning solutions using automatic coaters. In a case where after application the amount of solution applied is made uniform with a squeegee or a squeegee roller, a better result can be obtained.

In general, the amount of surface-adjusting solution applied is suitably from 0.03 to 0.8 g/m² (dry mass). If necessary the planographic printing plate onto which the surface-adjusting solution is applied can be dried, and then the plate is heated to a high temperature by means of a burning processor (for example, a burning processor (BP-1300) sold by Fuji Photo Film Co., Ltd.) or the like. In this case, the heating temperature and the heating time, which depend on the kind of components forming the image, are preferably from 180 to 300°C and from 1 to 20 minutes, respectively.

The planographic printing plate thus baked may further be subjected to treatments which have been conventionally conducted, such as a water-washing treatment and gum coating. However, in a case where a surface-adjusting solution containing a water soluble polymer compound or the like is used, the so-called desensitizing treatment (for example, gum coating) can be omitted. The planographic printing plate obtained as a result of such treatments is applied to an offset printing machine or to some other printing machine, and is used for printing on a great number of sheets.

Thus obtained planographic printing plate precursor according to the invention is capable of recording at high sensitivity, exhibits wide development latitude, irrespective of the variation in the activity of the developer, thereby achieving excellent image forming properties, as well as excellent inking property of an image portion during the printing.

### EXAMPLES

The invention will be explained by way of examples, which, however, do not limit the scope of the invention.

### (Preparation of support)

Using a JIS-A-1050 aluminum plate having a thickness of 0.3 mm, the aluminum plate was treated by combining the following steps to prepare supports A, B, C and D.

### (a) Mechanical surface roughening treatment

While a suspension containing a polishing agent (silica sand) with a specific gravity of 1.12 and water was supplied as a polishing slurry to the a surface of each aluminum sheet, the mechanical surface roughening was carried out by rotating roller type nylon brushes. The average particle size of the polishing agent was 8 µm and the maximum particle size was 50 µm. The material of the nylon brushes was 6-10 nylon and hair length and hair diameters were 50 mm and 0.3 mm, respectively. The nylon brushes were produced by implanting the hairs densely in holes formed in stainless cylinders with a diameter of φ300 mm. Three rotating brushes were used. Two supporting rollers (φ200 mm diameter) were placed in lower parts of the brushes with a separation distance of 300 mm. The brush rollers were pushed until the load of the driving motor for rotating the brushes was increased by 7 kW or more from the load before the brush rollers being pushed against the aluminum sheet. The rotation direction of the brushes was the same as the moving direction of the aluminum sheet. The rotation speed of the brushes was 200 rpm.

### (b) Alkaline etching treatment

Etching treatment was carried out by spraying an aqueous NaOH solution (NaOH concentration being 26% by weight and also containing an aluminum ion 6.5% by weight) to the aluminum plate at 70°C, to dissolve the aluminum sheet by an amount of 6 g/m². After that, the aluminum sheet was washed with water by spraying.

### (c) Desmut treatment

Desmut treatment was carried out by spraying an aqueous solution of 1 % by weight nitric acid (containing an aluminum ion at concentration of 0.5% by weight) at 30°C, and then the resulting aluminum sheet was washed with water. As the aqueous nitric acid solution used for the desmutting, waste solution from a step of the electrochemical surface roughening with an aqueous nitric acid solution by AC (alternate current) was used.

### (d) Electrochemical surface roughening treatment

Electrochemical surface roughening treatment was carried out continuously by using 60 Hz AC voltage. The electrolytic solution used in this case was an aqueous solution of nitric acid (the concentration being 10.5 g/L and also containing aluminum ion by 5 g/L) at 50°C. The electrochemical surface roughening was carried out using an AC power waveform which had a trapezoidal rectangular waveform, with the time TP from a zero current value to the peak being 0.8 msec and DutyUTY ratio 1 : 1, and employing a carbon electrode as an opposed electrode. Ferrite was used as an auxiliary anode. A radial cell type electrolytic bath was used.

The current density was 30 A/dm² at the peak value of the current and the total electricity quantity was 220 C/dm² when the aluminum sheet was used as an anode. Five percent of the electric current flowing from the electric power was shunted to the auxiliary anode.

After that, the resulting aluminum sheet was washed with a water spray.

### (e) Alkali etching treatment

Etching treatment was carried out at 32°C for the aluminum sheet at by spraying a solution with sodium hydroxide concentration 26% by weight and aluminum ion concentration 6.5% by weight onto the aluminum sheet. 0.2 g/m² of the aluminum sheet was dissolved, to remove the smut of which main component was aluminum hydroxide produced during the electrochemical surface roughening by using alternating current in the prior step. The edge portions of the pits formed were dissolved to make the edge portions smooth. After that, the aluminum sheet was washed by spraying water spray.

### (f) Desmut treatment

Desmut treatment was carried out by spraying an aqueous solution of 15% by weight nitric acid (containing aluminum ion 4.5% by weight) at 30°C. Then the resulting aluminum sheet was washed by spraying water spray. As the aqueous nitric acid solution used for the desmut, waste solution from the step of the electrochemical surface roughening with an aqueous nitric acid solution by AC was used.

### (g) Electrochemical surface roughening treatment

Electrochemical surface roughening treatment was carried out continuously by using 60 Hz AC voltage. The electrolytic solution used in this step was an aqueous solution of hydrochloric acid (the concentration thereof being 7.5 g/L and also containing aluminum ion by 5 g/L) at 35°C. The AC power waveform had a trapezoidal rectangular waveform and a carbon electrode was used as an opposed electrode, to effect the electrochemical surface roughening treatment. Ferrite was used as an auxiliary anode. A radial cell type electrolytic bath was used.

The current density was 25 A/dm² at the peak value of the current and the total electricity quantity was 50 C/dm² when the aluminum sheet was used as an anode.

After that, the resulting aluminum sheet was washed with a water spray.

### (h) Alkali etching treatment

Etching treatment was carried out at 32°C for the aluminum sheet by spraying a solution containing 26 wt. % sodium hydroxide and 6.5 wt. % aluminum ion thereon, to dissolve 0.10 g/m² of the aluminum sheet, so as to remove the smut, of which main component is mainly aluminum hydroxide produced during the electrochemical roughening treatment of the surface by using alternating current in the prior step. Further, the edge portions of the pits formed were dissolved to make the edge portions smooth. After that, the aluminum sheet was washed by spraying water spray.

### (i) Desmut treatment

Desmut treatment was is carried out by spraying with an aqueous solution of 25% by weight sulfuric acid (containing aluminum ion 0.5% by weight) at 60°C and then washing the resulting aluminum sheet with water spray.

### (j) Anodization treatment

As an electrolytic solution, sulfuric acid was used. The electrolytic solution contained sulfuric acid by 170 g/L (and contained aluminum ion 0.5% by weight). The temperature of the electrolytic solution was 43°C. After Then the aluminum sheet was washed with a water by spraying.

The electric current density was about 30 A/dm². Final oxide film thickness was about 2.7 g/m².

### <Support A>

Each of the foregoing (a) through (j) steps was sequentially carried out, and the amount of etching in the step (e) was controlled so as to be 3.4 g/m², such that support A was prepared.

### <Support B>

Support B was prepared by sequentially carrying out the aforementioned steps (a) to (j) but omitting the steps (g), (h) and (i).

### <Support C>

Respective steps were successively performed except that steps (a), (g), (h) and (i) among the aforementioned steps were omitted, such that support C was prepared.

### <Support D>

Respective steps were successively performed except that steps (a), (d), (e) and (f) among the aforementioned steps were omitted and a sum of an electricity amount in a (g) step was adjusted to be 450C/dm², such that support D was prepared.

Supports A, B, C and D as obtained above were subsequently subjected to the following hydrophilization treatment and undercoating treatment.

### (k) Alkali metal silicate salt treatment

An aluminum support obtained by anode oxidation treatment was immersed in a treatment bath containing 1 mass % aqueous solution of No. 3 sodium silicate at a temperature of 30°C for 10 seconds, thereby effecting alkali metal silicate salt treatment (silicate treatment). Thereafter, water washing by spraying water was performed. Thereupon, a silicate adhering amount was 3.6 mg/m².

### (Undercoating treatment)

An undercoating solution having the following composition was coated on the aluminum support thus obtained after alkali metal silicate salt treatment, and was dried at 80°C for 15 seconds. A covering amount after drying was 15 mg/m².

| <Undercoating solution composition> | |
|---|---|
| • Following polymer compound | 0.3 g |
| • Methanol | 100 g |
| • Water | 1.0 g |

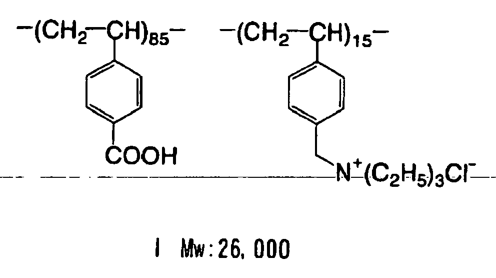

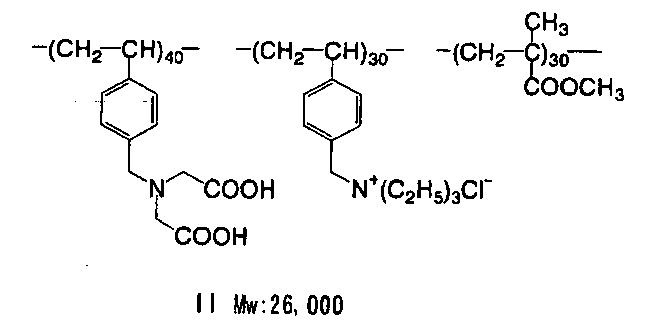

### [Examples 1 through 3 and Comparative Examples 1 and 2]

- On the substrate with an undercoat layer, which was obtained according to the method, a recording layer coating solution A having a composition below was coated by use of a wire-bar. After coating, it was dried at 140°C for 60 sec for a total coating amount to be 1.80 g/m². Thereby, positive planographic printing plate precursors according to examples 1 through 3 and comparative examples 1 and 2 were obtained.

| <Recording Layer Coating Solution A> | |
|---|---|
| • Particular structure unit-containing polymer described in Table 1 | 0.75 g |
| • M-cresol/p-cresol novolak resin (molar ratio: 60: 40, weight average molecular weight: 5,000) | 0.25 g |
| • Onium salt described in Table 1 | 0.25 g |
| • P-toluenesulfonic acid | 0.003 g |
| • Tetrahydrophthalic anhydride | 0.03 g |
| • Cyanine dye X (structure described below) | 0.017 g |
| • Victoria pure blue (dye in which a counter anion of BOH is replaced by 1-naphthalene sulfonate anion) | 0.015 g |
| • Gamma-butyl lactone | 10 g |
| • Methyl ethyl ketone | 10 g |
| • 1-methoxy-2-propanol | 1 g |

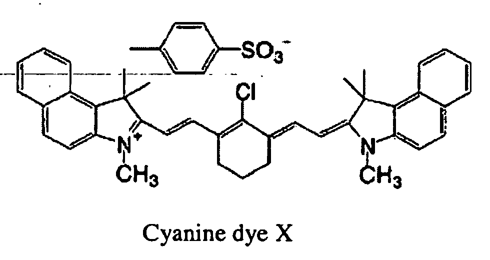

### [Examples 4 through 6, Comparative Examples 3 and 4]

On the substrate with an undercoat layer, which was obtained according to the method similar to examples 1 through 3, a recording layer coating solution B having a composition below was coated by use of a wire-bar. After coating, it was dried at 150°C for 100 sec for a total coating amount to be 1.40 g/m². Thereby, positive planographic printing plate precursors according to examples 4 through 6 and comparative examples 3 and 4 were obtained.

| <Recording Layer Coating Solution B> | |
|---|---|
| • Particular structure unit-containing polymer described in Table 1 | 12.0% |
| • Onium salt described in Table 1 | 3.0% |
| • Cyanine dye X (the above structure) | 0.12% |
| • Crystal violet | 0.05 % |
| • Fluorinated surfactant (trade name: Megafack F-780, manufactured by Dainippon Ink and Chemicals, Inc.) | 0.03% |
| □ Methyl ethyl ketone | 84.8 % |

### [Evaluation of Planographic Printing Plate Precursor]

Next, the positive planographic printing plate precursors according to example 1 through 6 and comparative examples 1 through 4 were subjected to performance evaluation. The evaluation test was carried out with each of the samples which was, after the recording layer coating, stored at 25°C for 30 days.

### (Evaluation of Development Latitude)

Next, the positive planographic printing plate precursors obtained according to examples 1 through 6 and comparative examples 1 through 4 was mounted on TrendSetter 800 (trade name, manufactured by CREO Co., Ltd.) and a test pattern was drawn imagewise (exposed) under conditions of a beam intensity of 10.0 W and a drum rotation speed of 250 rpm.

Subsequently, each of the planographic printing plate precursors according to examples 1 through 3 and comparative examples 1 and 2 was mounted on a PS processor LP-940HII (trade name, manufactured by Fuji Photo Film Co., Ltd.) charged with a solution obtained by blowing carbon dioxide gas in a water-diluted (1: 9) developer DT-2R (trade name, manufactured by Fuji Photo Film Co., Ltd.) such that it had 37 mS/cm of the electric conductivity and a water-diluted (1: 1) solution of Finisher FG-1 (trade name, manufactured by Fuji Photo Film Co., Ltd.), and developed with a liquid temperature maintained at 30°C for a developing time period of 12 sec. After that, an appropriate amount of the water-diluted (1: 9) solution of the DT-2R was added to a developer to control the electric conductivity to be 39 mS/cm, followed by developing the planographic printing plate precursor on which a test pattern the same as before had been drawn imagewise. Furthermore, by raising the electric conductivity every time by 2 mS/cm, the operation was continued until remarkable film reduction due to development of an image was observed.

Furthermore, each of the planographic printing plate precursors according to examples 4 through 6 and comparative examples 3 and 4 was mounted on a PS processor LP-940HII (trade name, manufactured by Fuji Photo Film Co., Ltd.) charged with a solution obtained by blowing carbon dioxide gas in a water-diluted (1: 9) developer DT-2R (trade name, manufactured by Fuji Photo Film Co., Ltd.) such that it had 50 mS/cm of the electric conductivity and a water-diluted (1:1) solution of Finisher FG-1 (trade name, manufactured by Fuji Photo Film Co., Ltd.). Evaluation was carried out according to a method similar to examples 1 through 3.

In the developed plates according to examples and comparative examples, the plates developed at the respective electric conductivities were observed with a 50 times magnification loupe of whether or not there were stains or colorings caused by a residual film due to insufficiently development at non-image portion, and the (limit) electric conductivity of the developer at which the development was excellently carried out was determined. Subsequently, another limit electric conductivity at which the development inhibition at a black (full-image) portion was somehow maintained during development was determined. Specifically, the image density of a black portion before development was measured with GRETAG reflection densitometer D 196 (trade name, manufactured by Gretag Macbeth), and the another limit electric conductivity of the developer at which the image density of a black portion was decreased to 0.10 or less was determined.

A width between the limit electric conductivity where excellent development is carried out and another limit electric conductivity where the development inhibition at the black portion is somehow maintained is taken as the development latitude. As the numerical value thereof is larger, the development latitude is wider. Results are shown in Table 1.

### (Evaluation of Inking Property)

Each of the positive planographic printing plate precursors obtained according to examples and comparative examples was mounted on Trendsetter 3244 (trade name, manufactured by CREO Co., Ltd.) and a test pattern was drawn imagewise (exposed) under conditions of a beam intensity of 10.0 W and a drum rotation speed of 250 rpm.

After the exposing under the above conditions, each of the planographic printing plate precursors according to examples 1 through 3 and comparative examples 1 and 2 was mounted on a PS processor LP-940H (trade name, manufactured by Fuji Photo Film Co., Ltd.) charged with a developer DT-2 (trade name, manufactured by Fuji Photo Film Co., Ltd.) (the electric conductivity thereof was controlled to 43 mS/cm by diluting) and a finisher FP-2W (trade name, manufactured by Fuji Photo Film Co., Ltd.) (diluted at 1: 1), and developed with a temperature maintained at 30°C for a developing time period of 12 sec.

Furthermore, each of the planographic printing plate precursors according to examples 4 through 6 and comparative examples 3 and 4 was mounted on a PS processor LP-940HII (trade name, manufactured by Fuji Photo Film Co., Ltd.) charged with a solution obtained by blowing carbon dioxide gas in a water-diluted (1:9) developer DT-2R (trade name, manufactured by Fuji Photo Film Co., Ltd.) so that the electric conductivity thereof was adjusted to 54 mS/cm, and developed with a temperature maintained at 30°C for a developing time period of 12 sec.

Thereafter, each of the printing plates according to examples and comparative examples was mounted on a Heidel KOR-D machine to print, the number of printed matters, from the beginning of the printing to the first one at which normal affinity of ink at an image portion was observed, was counted, and it was judged that the number is smaller, the inking property is better. Results are shown in Table 1.

**[Table 1]**

| | Substrate | Compound of undercoat layer | Specific structure polymer or comparative polymer | Onium salt | Development latitude (mS/cm) | Inking property (sheet) |
|---|---|---|---|---|---|---|
| Example 1 | A | I | a | C-1 | 12 | 10 |
| Example 2 | B | II | b | C-2 | 12 | 5 |
| Example 3* | C | I | c | C-10 | 11 | 5 |
| Comparative example 1 | A | I | g | - | 4 | 75 |
| Comparative example 2 | B | II | (i) | C-1 | 5 | 75 |
| Example 4* | A | I | d | C-12 | 10 | 10 |
| Example 5* | B | II | e | C-19 | 10 | 10 |
| Example 6* | D | I | f | C-27 | 11 | 10 |
| Comparative example 3 | C | I | h | - | 4 | 100 |
| Comparative example 4 | D | II | (i) | C-2 | 5 | 100 |

| | | | | | | |
|---|---|---|---|---|---|---|
| * denotes reference example | | | | | | |

In the Table 1, the "specific structure polymers" are as follows.

### [Specific structure polymer]

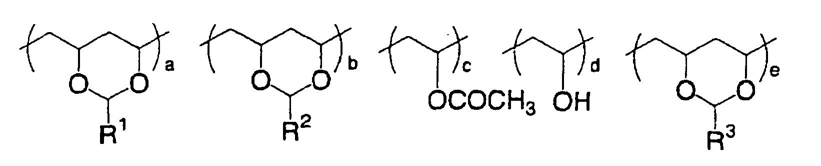

Specific structure polymer (a): (a/b/c/d/e = 36/37/2/25/0; weight average molecular weight: 16,000)
   R¹ = n-butyl group
   R² = 4-hydroxybenzyl group
• Specific structure polymer (b): (a/b/c/d/e = 12/49/17/22/0; weight average molecular weight: 14,000)
   R¹ = n-butyl group
   R² = 3-hydroxybenzyl group
• Specific structure polymer (c): (a/b/c/d/e = 30/41/2/20/9; weight average molecular weight: 18,000)
   R¹ = n-butyl group
   R² = 2-hydroxybenzyl group
   R³ = glyoxylate group
• Specific structure polymer (d): (a/b/c/d/e = 21/43/2/24/10; weight average molecular weight: 16,000)
   R¹ = n-butyl group
   R² = 3-hydroxybenzyl group
   R³ = propargyl group
• Specific structure polymer (e): (a/b/c/d/e = 38/42/2/18/0; weight average molecular weight: 18,000)
   R¹ = n-butyl group
   R² = 2-hydroxybenzyl group
• Specific structure polymer (f): (a/b/c/d/e = 25/38/12/26/0; weight average molecular weight: 16,000)
   R¹ = n-butyl group
   R² = 4-hydroxybenzyl group
• Specific structure polymer (g): (a/b/c/d/e = 16/10/12/44/18; weight average molecular weight: 18,000)
   R¹ = n-isovaleryl group
   R² = 2-hydroxybenzyl group
   R³⁶ = 4-formylphenoxy acetate group
• Specific structure polymer (h): (a/b/c/d/e = 14/44/2/40/0; weight average molecular weight: 16,000)
   R¹ = n-butyl group
   R² = 3,5-dibromo-4-hydroxybenzyl group
• Polymer (i): comparative polymer

### N-(4-aminoshulfonylphenyl) methacrylamide/acrylonitrile/methyl methacrylate (36/34/30, weight average molecular weight 50,000)

As shown in Table 1, it was found that in the planographic printing plate precursors according to examples 1 through 6, which include a specific structure polymer and an onium salt and an infrared absorber, both those of which recording layer has the single layer structure and those of which recording layer has the separate phase structure similarly exhibit wide development latitude and excellent inking property of an image portion.

On the other hand, the planographic printing plate precursors according to comparative examples 2 and 4, in which a composition that does not contain the specific structure polymer is used in the recording layer, were inferior in both of the development latitude and the inking property of the image portion to the planographic printing plate precursors according to examples 1-6. Furthermore, it was found that the planographic printing plate precursors according to comparative examples 1 and 3, in which a composition that contains the specific structure polymer but does not contain the onium salt is used, were very poor in both of the development latitude and the inking property of the image portion.

## Claims

1. A positive planographic printing plate precursor, comprising:
a substrate; and
a recording layer that is disposed on the substrate and contains a polymer compound represented by formula (I) below, an onium salt represented by formula (A) below, an infrared absorber and a novolac resin 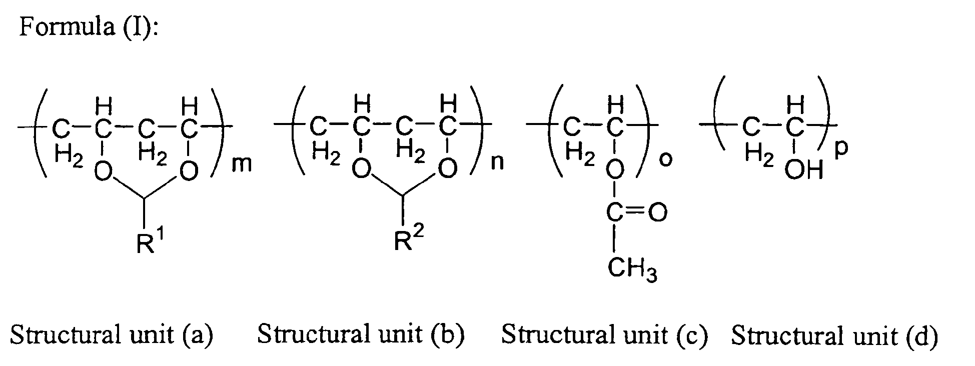
wherein, in formula (I), R¹ represents a hydrocarbon group and R² represents an aromatic group having, as a substituent group, a hydroxyl group. M = 5 to 40 % by mole, n = 10 to 60 % by mole, o = 1 to 20 % by mole and p = 5 to 50 % by mole;
Formula (A): M⁺X⁻
wherein, in the formula (A), M⁺ represents a cation selected from sulfonium or iodonium that may have a substituent group, and X- represents a counter anion.

2. The positive planographic printing plate precursor of claim 1, wherein R¹ of structural unit (a) is an alkyl group having 1 to 12 carbon atoms.

3. The positive planographic printing plate precursor of claim 2, wherein R¹ of structural unit (a) is an alkyl group having 3 to 10 carbon atoms.

4. The positive planographic printing plate precursor of claim 1, wherein an aromatic ring contained in R² of structural unit (b) is selected from the group consisting of a benzene ring, a naphthalene ring and an anthracene ring.

5. The positive planographic printing plate precursor of claim 1, wherein R² of structural unit (b) is an aromatic group having a monovalent non-metal atomic group other than hydrogen.

6. The positive planographic printing plate precursor of claim 1, wherein the polymer compound is a polymer compound represented by formula (II) below 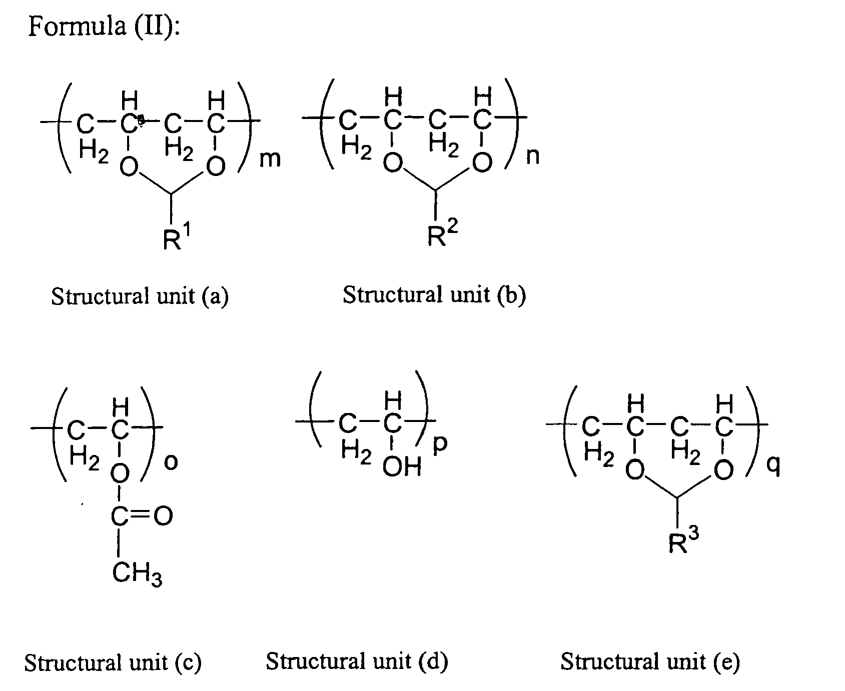 wherein, in structural unit (e), q is in the range of 0 to 20 % by mole, and R3 represents -(CH₂)ₓCOOH, -C ≡ CH or a group shown below and X represents an integer of 1 or more 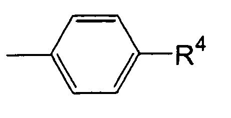 wherein the formula, R4 represents -COOH, -(CH₂)ₓCOOH, or -O-(CH₂)ₓCOOH and X represents an integer of 1 or more.

7. The positive planographic printing plate precursor of claim 1, wherein in formula (I), m is in the range of 10 to 35 % by mole.

8. The positive planographic printing plate precursor of claim 1, wherein in the formula (I), n is in the range of 20 to 55 % by mole.

9. The positive planographic printing plate precursor of claim 1, wherein in the formula (I), o is in the range of 2 to 15 % by mole.

10. The positive planographic printing plate precursor of claim 1, wherein in the formula (I), p is in the range of 10 to 45 % by mole.

11. The positive planographic printing plate precursor of claim 6, wherein in the formula (II), q is in the range of 3 to 17 % by mole.

## Patentansprüche

1. Positiv-Flachdruckplattenvorläufer, umfassend:
ein Substrat; und
eine Aufzeichnungsschicht, die auf dem Substrat angeordnet ist und eine Polymerverbindung, die durch die nachstehende Formel (I) repräsentiert wird, ein Oniumsalz, das durch die nachstehende Formel (A) repräsentiert wird, einen Infrarotabsorber und ein Novolakharz enthält: 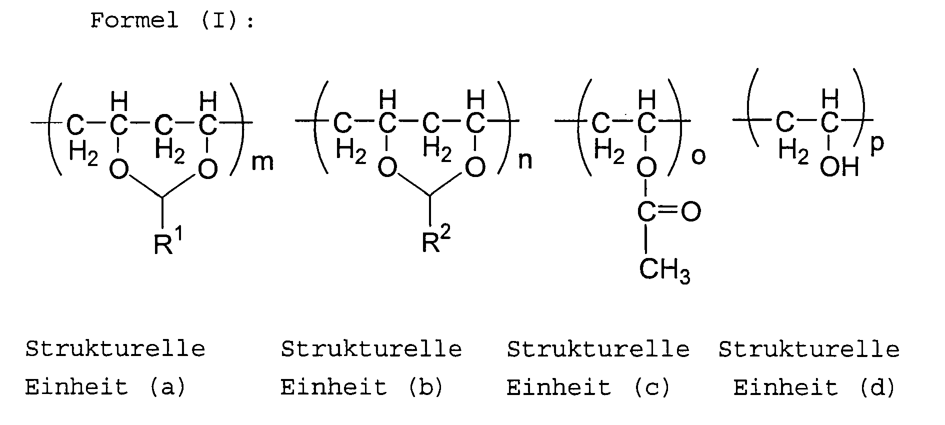
worin in Formel (I) R¹ eine Kohlenwasserstoffgruppe darstellt und R² eine aromatische Gruppe darstellt, die als eine Substituentengruppe eine Hydroxylgruppe aufweist.
m = 5 bis 40 Mol-%, n = 10 bis 60 Mol-%, o = 1 bis 20 Mol-% und p = 5 bis 50 Mol-%;
Formel (A): M⁺X⁻
worin in der Formel (A) M⁺ ein Kation darstellt, das aus Sulfonium oder Iodonium, welches eine Substituentengruppe aufweisen kann, ausgewählt ist, und X⁻ ein Gegenanion darstellt.

2. Positiv-Flachdruckplattenvorläufer gemäß Anspruch 1, worin R¹ der strukturellen Einheit (a) eine Alkylgruppe mit 1 bis 12 Kohlenstoffatomen ist.

3. Positiv-Flachdruckplattenvorläufer gemäß Anspruch 2, worin R¹ der strukturellen Einheit (a) eine Alkylgruppe mit 3 bis 10 Kohlenstoffatomen ist.

4. Positiv-Flachdruckplattenvorläufer gemäß Anspruch 1, worin ein aromatischer Ring, der in R² der strukturellen Einheit (b) enthalten ist, aus der Gruppe ausgewählt ist, die aus einem Benzolring, einem Naphthalinring und einem Antracenring besteht.

5. Positiv-Flachdruckplattenvorläufer gemäß Anspruch 1, worin R² der strukturellen Einheit (b) eine aromatische Gruppe ist, die eine einwertige atomare Nicht-Metallgruppe, die sich von Wasserstoff unterscheidet, aufweist.

6. Positiv-Flachdruckplattenvorläufer gemäß Anspruch 1, worin die Polymerverbindung eine Polymerverbindung ist, die durch nachstehende Formel (II) dargestellt wird: 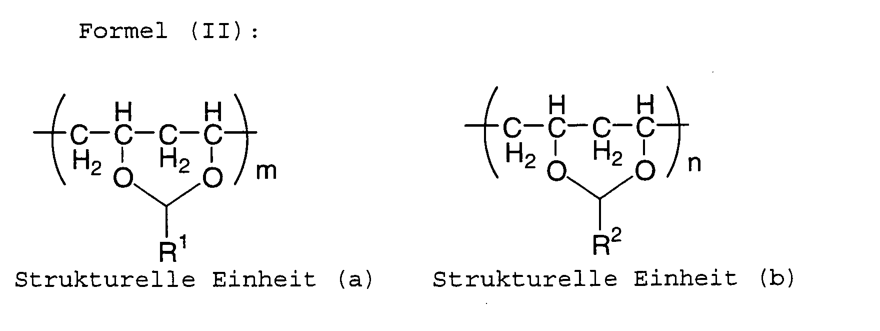 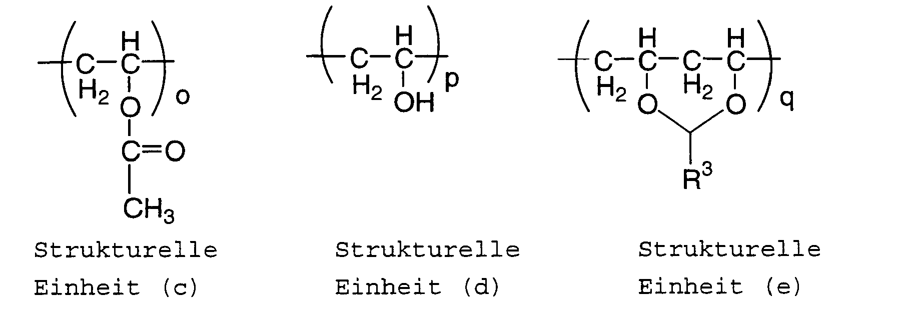 worin in der strukturellen Einheit (e) q im Bereich von 0 bis 20 Mol-% liegt und R³ -(CH₂)ₓCOOH, -C≡CH oder eine nachstehend gezeigte Gruppe darstellt und x eine ganze Zahl von 1 oder größer darstellt 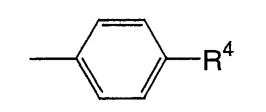 worin in der Formel R⁴ -COOH, -(CH₂)ₓCOOH, oder -O-(CH₂)ₓCOOH darstellt und X eine ganze Zahl von 1 oder größer darstellt.

7. Positiv-Flachdruckplattenvorläufer gemäß Anspruch 1, worin in Formel (I) m im Bereich von 10 bis 35 Mol-% liegt.

8. Positiv-Flachdruckplattenvorläufer gemäß Anspruch 1, worin in der Formel (I) n im Bereich von 20 bis 55 Mol-% liegt.

9. Positiv-Flachdruckplattenvorläufer gemäß Anspruch 1, worin in der Formel (I) o im Bereich von 2 bis 15 Mol-% liegt.

10. Positiv-Flachdruckplattenvorläufer gemäß Anspruch 1, worin in der Formel (I) p im Bereich von 10 bis 45 Mol-% liegt.

11. Positiv-Flachdruckplattenvorläufer gemäß Anspruch 6, worin in der Formel (II) q im Bereich von 3 bis 17 Mol-% liegt.

## Revendications

1. Précurseur positif de plaque d'impression planographique, comprenant :
un substrat ; et
une couche d'enregistrement qui est disposée sur le substrat et contient un composé polymère représenté par la formule (I) ci-dessous, un sel d'onium représenté par la formule (A) ci-dessous, un agent absorbant l'infrarouge et une résine novolaque 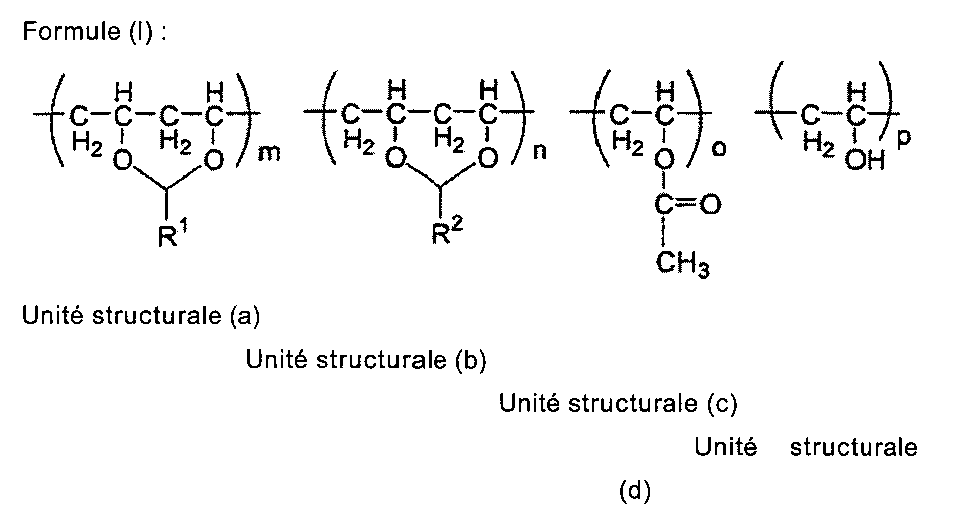 dans lequel, dans la formule (I), R¹ représente un groupe hydrocarboné et R² représente un groupe aromatique ayant, en tant que groupe de substitution, un groupe hydroxyle. M = 5 à 40 % en mole, n = 10 à 60 % en mole, o = 1 à 20 % en mole et p = 5 à 50 % en mole;
Formule (A) : M⁺X⁻
dans lequel, dans la formule (A), M⁺ représente un cation sélectionné parmi un sulfonium ou un iodonium qui peut avoir un groupe de substitution, et X⁻ représente un contre-anion.

2. Précurseur positif de plaque d'impression planographique selon la revendication 1, dans lequel R¹ de l'unité structurale (a) est un groupe alkyle ayant 1 à 12 atomes de carbone.

3. Précurseur positif de plaque d'impression planographique selon la revendication 2, dans lequel R¹ de l'unité structurale (a) est un groupe alkyle ayant 3 à 10 atomes de carbone.

4. Précurseur positif de plaque d'impression planographique selon la revendication 1, dans lequel un cycle aromatique contenu dans R² de l'unité structurale (b) est sélectionné dans le groupe constitué par un cycle benzène, un cycle naphtalène et un cycle anthracène.

5. Précurseur positif de plaque d'impression planographique selon la revendication 1, dans lequel R² de l'unité structurale (b) est un groupe aromatique ayant un groupe atomique monovalent non métallique autre que l'atome hydrogène.

6. Précurseur positif de plaque d'impression planographique selon la revendication 1, dans lequel le composé polymère est un composé polymère représenté par la formule (11) ci-dessous 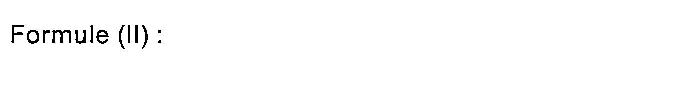 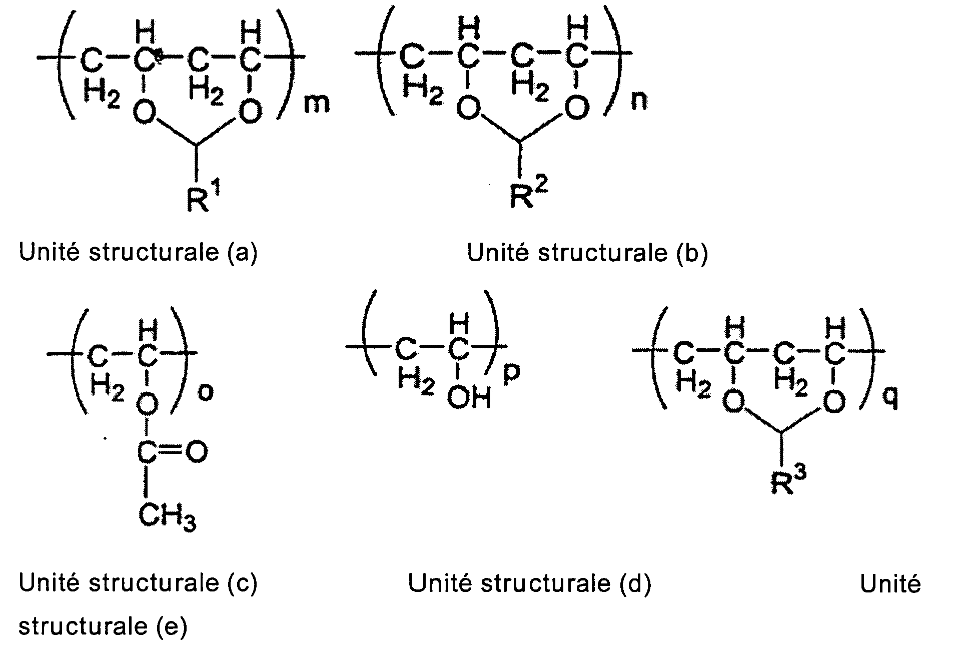 dans lequel, dans l'unité structurale (e), q se situe dans la plage de 0 à 20 % en mole, et R³ représente -(CH₂)ₓCOOH, -C=CH ou un groupe montré ci-dessous et X représente un nombre entier égal à 1 ou supérieur 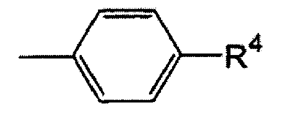 dans lequel, dans la formule, R⁴ représente -COOH, -(CH₂)ₓCOOH, ou -O-(CH₂)ₓCOOH et X représente un nombre entier égal à 1 ou supérieur.

7. Précurseur positif de plaque d'impression planographique selon la revendication 1, dans lequel dans la formule (1), m se situe dans la plage de 10 à 35 % en mole.

8. Précurseur positif de plaque d'impression planographique selon la revendication 1, dans lequel dans la formule (1), n se situe dans la plage de 20 à 55 % en mole.

9. Précurseur positif de plaque d'impression planographique selon la revendication 1, dans lequel dans la formule (1), o se situe dans la plage de 2 à 15 % en mole.

10. Précurseur positif de plaque d'impression planographique selon la revendication 1, dans lequel dans la formule (1), p se situe dans la plage de 10 à 45 % en mole.

11. Précurseur positif de plaque d'impression planographique selon la revendication 6, dans lequel dans la formule (II), q se situe dans la plage de 3 à 17 % en mole.
